# EUROPEAN PATENT APPLICATION

(11) **EP 2 782 102 A1**
(43) Date of publication of application: **24.09.2014**
(21) Application number: 12849394.7
(22) Date of filing: 09.11.2012
(51) Int. Cl.: H01B 1/22, H01L 31/0224, H01L 31/068

(54) **PASTE COMPOSITION FOR ELECTRODE, AND SOLAR CELL ELEMENT AND SOLAR CELL**

(30) Priority: 14.11.2011 JP 2011249120
(71) Applicant: Hitachi Chemical Co., Ltd., Chiyoda-ku Tokyo 100-6606 (JP)
(72) Inventor: ADACHI, Shuichiro, Tsukuba-shi Ibaraki 300-4247 (JP); YOSHIDA, Masato, Tsukuba-shi Ibaraki 300-4247 (JP); NOJIRI, Takeshi, Tsukuba-shi Ibaraki 300-4247 (JP); KURIHARA, Yoshiaki, Tsukuba-shi Ibaraki 300-4247 (JP); KATO, Takahiko, Hitachi-shi Ibaraki 319-1292 (JP)
(74) Representative: HOFFMANN EITLE
(86) International application number: PCT/JP2012/079157
(87) International publication number: WO 2013/073478

(57) **Abstract**

The present invention provides a paste composition for an electrode, including a phosphorus-containing copper alloy particle, a tin-containing particle, a nickel-containing particle, a glass particle, a solvent, and a resin.

## Description

### BACKGROUND OF THE INVENTION

### Field of the Invention

The present invention relates to a paste composition for an electrode, a photovoltaic cell element, and a photovoltaic cell.

### Description of the Related Art

Generally, on a light receiving surface and a back surface of a silicon based photovoltaic cell, electrodes are formed. In order to output efficiently the electrical energy converted in a photovoltaic cell from incident light, it is necessary that the electrodes have sufficiently low volume resistivity and form a favorable ohmic contact with the silicon substrate. Especially, there is a tendency for an electrode on the light receiving surface to have a thin electrode width and a high electrode aspect ratio, in order to limit the incidence loss of sunlight to the minimum.

An electrode used on a light receiving surface of a photovoltaic cell is usually formed as follows. Namely, a texture (asperity) is formed on the light receiving surface side of a p-type silicon substrate; then by diffusing thermally phosphorus or the like at a high temperature to form an n-type silicon layer, on which a conductive composition is provided by screen printing or the like, followed by sintering in the atmosphere at 800°C to 900°C to form a light receiving surface electrode. The conductive composition for forming a light receiving surface electrode contains a conductive metal powder, a glass particle, various additives, and the like.

As the conductive metal powder, usually a silver powder is used. The reasons thereof include: the volume resistivity of a silver particle is as low as 1.6×10⁻⁶ Ω·cm; a silver particle can be sintered under the sintering condition mentioned above through auto-reduction; a favorable ohmic contact with a silicon substrate can be established; and the wettability of a solder material to an electrode made of a silver particle is superior, so that wiring materials such as a tab wire connecting electrically photovoltaic cell elements each other in forming a module system encapsulating photovoltaic cell elements with a glass substrate or the like can be well bonded.

As described above, a conductive composition containing a silver particle exhibits favorable characteristics as an electrode for a photovoltaic cell. Meanwhile, since silver is a noble metal and the base metal itself is expensive, and in perspective of a resource issue, a proposal of a conductive composition replacing a silver-containing conductive composition has been desired. Examples of a promising material replacing silver include a copper, which is utilized as a semiconductor wiring material. Copper is abundant in terms of resources and the cost of the base metal is approx. hundredth as low as silver. However, copper is a material that easily oxidizes at a high temperature of 200°C or higher in the atmosphere and consequently it is difficult to form an electrode according to the above described process.

To eliminate such a drawback of copper, disclosed is a copper particle which is hard to be oxidized by a high temperature sintering through imparting oxidation resistance to copper by means of various techniques (For example, see Japanese Patent Laid-Open (JP-A) No. 2005-314755 and JP-A No. 2004-217952).

### SUMMARY OF THE INVENTION

However, the oxidation resistance of the copper particles is limited to 300°C at most and at a temperature as high as 800°C to 900°C substantially all of them are oxidized, and consequently they have been not yet commercialized as a photovoltaic cell electrode. Further, since additives and the like added for imparting oxidation resistance disturb sintering of copper particles during sintering, there is consequently a problem that an electrode with such low volume resistivity as silver cannot be obtained.

There is another special process, by which a conductive composition using copper as a conductive metal powder is sintered in the atmosphere of nitrogen or the like for suppressing oxidization of copper.

When the above technique is applied, however, in order to suppress completely the oxidization of a copper particle, an environment sealed completely by the atmospheric gas is required, which is not suitable for mass production of a photovoltaic cell element from a perspective of a processing cost.

There is another problem in a property of an ohmic contact with a silicon substrate for applying copper to a photovoltaic cell electrode. Namely, even if an electrode composed of copper can be formed without causing oxidation during high temperature sintering, interdiffusion of copper and silicon may take place owing to the direct contact between copper and a silicon substrate, and a reactant phase (Cu₃Si) composed of copper and silicon may be occasionally formed on the interface of an electrode and a silicon substrate.

The formed Cu₃Si may occasionally reach the depth of several µm from the interface and sometimes cause a crack on the silicon substrate side. Further, in some cases it may penetrate through an n-type silicon layer formed previously on the silicon substrate and deteriorate the semiconductor performance (pn-junction property) of the photovoltaic cell. Further, the formed Cu₃Si may lift up an electrode made of copper, which may result in the inhibition of the adhesion with the silicon substrate and a decrease in the mechanical strength of the electrode.

The present invention was made in view of the problems with an object to provide a paste composition for an electrode, which can form an electrode with low resistivity, and further form a copper-containing electrode having a favorable ohmic contact with the silicon substrate, as well as a photovoltaic cell element and a photovoltaic cell having an electrode formed with the paste composition for an electrode.

### Means for solving the problems

To accomplish the object, the inventors of the present invention studied intensively to complete the present invention. More particularly, the present invention is as follows.
<1> A paste composition for an electrode, comprising a phosphorus-containing copper alloy particle, a tin-containing particle, a nickel-containing particle, a glass particle, a solvent, and a resin.
<2> The paste composition for an electrode according to <1>, wherein the phosphorus content of the phosphorus-containing copper alloy particle is preferably from 6% by mass to 8% by mass.
<3> The paste composition for an electrode according to <1> or <2>, wherein the tin-containing particle comprises at least one selected from the group consisting of a tin particle and a tin alloy particle having a tin content of 1% by mass or more.
<4> The paste composition for an electrode according to any one of <1> to <3>, wherein the nickel-containing particle comprises at least one selected from the group consisting of a nickel particle and a nickel alloy particle having a nickel content of 1% by mass or more.
<5> The paste composition for an electrode according to any one of <1> to <4>, wherein the glass particle has a glass softening point of 650°C or less and a crystallization initiation temperature of more than 650°C.
<6> The paste composition for an electrode according to any one of <1> to <5>, wherein the content of the tin-containing particle is from 5% by mass to 70% by mass when the total content of the phosphorus-containing copper alloy particle, the tin-containing particle and the nickel-containing particle is 100% by mass.
<7> The paste composition for an electrode according to any one of <1> to <6>, wherein the content of the nickel-containing particle is from 10% by mass to 60% by mass when the total content of the phosphorus-containing copper alloy particle, the tin-containing particle and the nickel-containing particle is 100% by mass.
<8> The paste composition for an electrode according to any one of <1> to <7>, wherein the total content of the phosphorus-containing copper alloy particle, the tin-containing particle, and the nickel-containing particle is from 70% by mass to 94% by mass, the content of the glass particle is from 0.1% by mass to 10% by mass, and the total content of the solvent and the resin is from 3% by mass to 29.9% by mass.
<9> The paste composition for an electrode according to any one of <1> to <8>, further comprising a silver particle/
<10> The paste composition for an electrode according to <9>, wherein the content of the silver particle is from 0.1 % by mass to 10% by mass when the total content of the phosphorus-containing copper alloy particle, the tin-containing particle, the nickel-containing particle, and the silver particle is 100% by mass.
<11> The paste composition for an electrode according to <9> or <19>, wherein the total content of the phosphorus-containing copper alloy particle, the tin-containing particle, the nickel-containing particle, and the silver particle is from 70% by mass to 94% by mass, the content of the glass particle is from 0.1% by mass to 10% by mass, and the total content of the solvent and the resin is from 3% by mass to 29.9% by mass.
<12> A photovoltaic cell element, comprising: a silicon substrate having a pn-junction; and an electrode that is a sintered product of the paste composition for an electrode according to any one of <1> to <11> which has been applied onto the silicon substrate.
<13> The photovoltaic cell element according to <12>, wherein the electrode comprises a Cu-Sn-Ni alloy phase and an Sn-P-O glass phase.
<14> The photovoltaic cell element according to <13>, wherein the Sn-P-O glass phase is arranged between the Cu-Sn-Ni alloy phase and the silicon substrate.
<15> A photovoltaic cell, comprising: the photovoltaic cell element according to any one of <12> to <14>; and a wiring material arranged on the electrode of the photovoltaic cell element.

According to the present invention, a paste composition for an electrode, which is capable of forming an electrode with low resistivity, and further forming a copper-containing electrode having a favorable ohmic contact with the silicon substrate, as well as a photovoltaic cell element and a photovoltaic cell having an electrode formed with the paste composition for an electrode can be provided.

### BRIEF DESCRIPTION OF THE DRAWINGS

FIG. 1 is a schematic cross-sectional view showing an example of a silicon photovoltaic cell element according to the present invention.
FIG. 2 is a schematic plan view showing an example of a light receiving surface of a silicon photovoltaic cell element according to the present invention.
FIG. 3 is a schematic plan view showing an example of a back surface of a silicon photovoltaic cell element according to the present invention.
FIG. 4 is a schematic plan view showing an example of a back surface-side electrode structure of a back-contact type photovoltaic cell element according to the present invention.
FIG. 5 is a schematic perspective view showing an example of an AA cross-section constitution of a back-contact type photovoltaic cell element according to the present invention.
FIG. 6 is a schematic perspective view showing an example of an AA cross-section constitution of a back-contact type photovoltaic cell element according to the present invention.
FIG. 7 is a schematic perspective view showing an example of an AA cross-section constitution of a back-contact type photovoltaic cell element according to the present invention.

### DETAILED DESCRIPTION OF THE INVENTION

The term "step" as used herein encompasses not only an independent step but also a step in which the anticipated effect of this step is achieved, even if the step cannot be clearly distinguished from another step. In addition, a numerical value range indicated by use of the term "to" as used herein refers to a range including the numerical values described before and after "to" as the minimum and maximum values, respectively. Unless specifically indicated, in a case in which each ingredient of a composition includes plural materials, the content of each ingredient of the composition denotes the total amount of the plural materials included in the composition.

### <Paste Composition for Electrode>

A paste composition for an electrode according to the present invention contains at least one phosphorus-containing copper alloy particle, at least one tin-containing particle, at least one nickel-containing particle, at least one glass particle, at least one solvent, and at least one resin. By virtue of such configuration, oxidation of copper during sintering in the atmosphere is suppressed and an electrode with low resistivity can be formed. Further, formation of a reactant phase of copper and a silicon substrate is suppressed and a favorable ohmic contact between a formed electrode and the silicon substrate can be established. This is regarded, for example, as follows.

First, when the paste composition for an electrode is subjected to a sintering treatment, a Cu-Sn alloy phase and a Sn-P-O glass phase are formed by a reaction between the phosphorus-containing copper alloy particle and tin-containing particle. By the formation of the Cu-Sn alloy phase, an electrode with low volume resistivity can be formed. Here, since the Cu-Sn alloy phase is formed at a relatively low temperature as low as about 500°C, sintering of an electrode at a low temperature becomes possible, by which reduction in process cost can be expected. The paste composition for an electrode further contains nickel-containing particle. As the result, it is considered that the Cu-Sn alloy phase and the nickel-containing particle further react with each other to form a Cu-Sn-Ni alloy phase. Since the Cu-Sn-Ni alloy phase is also formed at a relatively high temperature as high as 800°C, it is considered that an electrode with volume resistivity can be formed, while maintaining the oxidation resistance even in a sintering process at a higher temperature. Namely, use of the paste composition for an electrode can respond to a variety of conditions such as sintering an electrode at a low temperature to a high temperature. Accordingly, the paste composition for an electrode can be widely used as an electrode material for photovoltaic cells with the below-mentioned various structures.

The above Cu-Sn-Ni alloy phase forms a compact bulk in the electrode between Cu-Sn-Ni alloy phases or together with a Cu-Sn alloy phase which is further formed corresponding to a sintering condition, which functions as a conductive layer to form an electrode with low resistivity. It is thought that coexistence of the Cu-Sn alloy phase and the Cu-Sn-Ni alloy phase in the electrode does not decrease functions (for example, low volume resistivity). A compact bulk herein means a three-dimensional continuous structure constituted by massive Cu-Sn alloy phases and Cu-Sn-Ni alloy phases contacting each other compactly.

Further, in cases where an electrode is formed using a paste composition for an electrode on a substrate containing silicon (hereinafter also referred to simply as "silicon substrate"), an electrode with high adhesion to the silicon substrate can be formed, and a favorable ohmic contact between the electrode and the silicon substrate can be established.

The above can be explained, for example, as follows. A phosphorus-containing copper alloy particle, a tin-containing particle and a nickel-containing particle react with each other in a sintering process to form an electrode composed of a Cu-Sn-Ni alloy phase, a Sn-P-O glass phase and Cu-Sn alloy phase formed corresponding to a sintering condition. Since Cu-Sn-Ni alloy phase and the Cu-Sn alloy phase formed corresponding to a sintering condition are a compact bulk, the Sn-P-O glass phase is formed between the Cu-Sn-Ni alloy phase and the silicon substrate or between the Cu-Sn-Ni alloy phase and the Cu-Sn alloy phase and the silicon substrate, which is believed to improve the adhesion of the Cu-Sn alloy phase and the Cu-Sn-Ni alloy phase to the silicon substrate. Further, it is so conceivable that a favorable ohmic contact between an electrode formed by sintering and a silicon substrate can be established by the Sn-P-O glass phase functioning as a barrier layer prohibiting interdiffusion of copper and silicon. More particularly, it is conceivable that formation of a reaction phase (Cu₃Si) to be formed when an electrode containing copper is contacted directly with silicon and heated, can be suppressed to exhibit a favorable ohmic contact while maintaining adhesion to the silicon substrate and without deteriorating the semiconductor performance (for example, pn-junction property).

Namely, by combining a phosphorus-containing copper alloy particle with a tin-containing particle and a nickel-containing particle in the paste composition for an electrode, and firstly utilizing the reducing property of a phosphorus atom in a phosphorus-containing copper alloy particle with respect to an oxidized copper, an electrode having superior oxidation resistance and low volume resistivity is formed. Next by a reaction between the phosphorus-containing copper alloy particle and the tin-containing particle and the nickel-containing particle, while maintaining the volume resistivity low, a conductive layer composed of a Cu-Sn-Ni alloy phase and a Cu-Sn alloy phase formed corresponding to a sintering condition, and an Sn-P-O glass phase are formed. In addition, for example, by the Sn-P-O glass phase functioning as a barrier layer that prevents the interdiffusion of copper and silicon, the formation of a reactant phase between the electrode and the silicon substrate is suppressed, and a favorable ohmic contact with the copper electrode can be established. It is conceivable that the above two characteristic mechanisms can be exercised in a series of sintering processes.

Such an effect can be generally exerted when an electrode is formed with a paste composition for an electrode according to the present invention on a substrate containing silicon, and there is no particular restriction on a type of a substrate containing silicon. Examples of a substrate containing silicon include a silicon substrate for constituting a photovoltaic cell and a silicon substrate for producing a semiconductor device other than a photovoltaic cell.

### (Phosphorous-containing Copper Alloy Particles)

The paste composition for an electrode contains at least one phosphorus-containing copper alloy particle. As the phosphorous-containing copper alloy, a brazing material called copper phosphorus brazing (phosphorous concentration: approximately 7% by mass or less) is known. The copper phosphorus brazing is used as a copper-to-copper bonding agent, but by using the phosphorous-containing copper alloy particles in the paste composition for an electrode according to the present invention, and utilizing the reduction property of phosphorous with respect to a copper oxide, an electrode having an excellent oxidation resistance and a low volume resistivity can be formed. Furthermore, it becomes possible to sinter the electrode at a low temperature, and as a result, an effect of reducing a process cost can be attained.

In the present invention, from the perspectives of oxidation resistance and low volume resistivity, the content of phosphorous included in the phosphorous-containing copper alloy particle is preferably from 6% by mass to 8% by mass, more preferably from 6.3% by mass to 7.8% by mass, and even more preferably from 6.5% by mass to 7.5% by mass. By setting the content of phosphorous included in the phosphorous-containing copper alloy to 8% by mass or less, a lower resistivity can be attained, and also, the productivity of the phosphorous-containing copper alloy is excellent. Further, by setting the content of phosphorous included in the phosphorous-containing copper alloy to 6% by mass or more, superior oxidation resistance can be attained.

The content of phosphorous included in the phosphorous-containing copper alloy can be measured by using a high frequency inductively-coupled plasma atomic emission spectrometer (ICP-AES).

The phosphorous-containing copper alloy particle is an alloy including copper and phosphorous and it may further contain other atoms. Examples of other atoms include Ag, Mn, Sb, Si, K, Na, Li, Ba, Sr, Ca, Mg, Be, Zn, Pb, Cd, Tl, V, Sn, Al, Zr, W, Mo, Ti, Co, Ni, and Au.

Furthermore, the content of other atoms included in the phosphorous-containing copper alloy particle can be set to, for example, 3% by mass or less in the phosphorous-containing copper alloy particle, and from the perspectives of the oxidation resistance and low volume resistivity, it is preferably 1% by mass or less.

The phosphorous-containing copper alloy particle may be used singly or in combination of two or more kinds thereof.

The average particle diameter of the phosphorous-containing copper alloy particle is not particularly limited, and it is preferably from 0.4 µm to 10 µm, and more preferably from 1 µm to 7 µm in terms of an average particle diameter when the cumulative weight is 50% (hereinafter abbreviated as "D50%" in some cases). By setting the particle diameter to 0.4 µm or more, the oxidation resistance is improved more effectively. Further, by setting the particle diameter to 10 µm or less, the contact area at where the phosphorous-containing copper alloy particles contact with each other or the contact area at where the tin-containing particle and nickel-containing particle mentioned below contact with each other increase, whereby the volume resistivity of the electrode to be formed is reduced more effectively. The average particle diameter of the phosphorous-containing copper alloy particle is measured using a MICROTRACK particle distribution analyzer (manufactured by Nikkiso Co., Ltd., MT3300).

In addition, the shape of the phosphorous-containing copper alloy particle is not particularly limited, and it may be any one of an approximately spherical shape, a flat shape, a block shape, a plate shape, a scale-like shape, or the like. From the perspectives of the oxidation resistance and the low volume resistivity, the shape of the phosphorous-containing copper alloy particle is preferably an approximately spherical shape, a flat shape, or a plate shape.

The content of the phosphorous-containing copper alloy particle in the paste composition for an electrode is not limited. From the perspective of low volume resistivity, the content of the phosphorous-containing copper alloy particle in the paste composition for an electrode is preferably from 15% by mass to 75% by mass, more preferably from 18% by mass to 70% by mass, and even more preferably from 20% by mass to 65% by mass.

The content of the phosphorous-containing copper alloy particle in the paste composition for an electrode can be measured by using a high frequency inductively-coupled plasma atomic emission spectrometer (ICP-AES) or a high frequency inductively-coupled plasma mass spectrometer (ICP-MS). When the content of the phosphorous-containing copper alloy particle is measured using these apparatuses, the content of the phosphorous-containing copper alloy particle is measured by using a paste composition from which the solvent has been removed.

A phosphorous-containing copper alloy can be prepared by a generally used method. Further, the phosphorous-containing copper alloy particle can be prepared by a general method for preparing metal powders using a phosphorous-containing copper alloy that is prepared so as to give a desired phosphorous content, and it can be prepared by, for example, a general method using a water atomization method. The water atomization method is described in Handbook of Metal (MARUZEN CO., LTD. Publishing Dept.) or the like.

Specifically, for example, a desired phosphorous-containing copper alloy particle can be prepared by dissolving a phosphorous-containing copper alloy, forming a powder by nozzle spray, drying the obtained powders, and classifying them. Further, a phosphorous-containing copper alloy particle having a desired particle diameter can be prepared by appropriately selecting the classification condition.

### (Tin-containing Particle)

The paste composition for an electrode contains at least one tin-containing particle. By containing a tin-containing particle, an electrode having low volume resistivity can be formed in a sintering process described below.

There is no particular restriction on the tin-containing particle, insofar as it is a particle containing tin. Among others, it is preferably at least one selected from the group consisting of tin particles and tin alloy particles, and preferably at least one selected from the group consisting of tin particles and tin alloy particles having a tin content of 1% by mass or more.

There is no particular restriction on the purity of tin in a tin particle. For example, the purity of a tin particle may be 95% by mass or more, is preferably 97% by mass or more, and more preferably 99% by mass or more.

There is no particular restriction on the kind of an alloy for a tin alloy particle, insofar as it is an alloy particle containing tin. Among others, from perspectives of the melting point of a tin alloy particle and the reactivity with a phosphorus-containing copper alloy particle and a nickel-containing copper alloy particle, a tin alloy particle with the tin content of 1% by mass or more is preferable, a tin alloy particle with the tin content of 3% by mass or more is more preferable, a tin alloy particle with the tin content of 5% by mass or more is further preferable, and a tin alloy particle with the tin content of 10% by mass or more is especially preferable.

The content of the tin in the tin-containing particle can be measured by using an X-ray fluorescence (XRF) spectrometer, for example, Type MESA-500W manufactured by HORIBA, Ltd.

Examples of a tin alloy particle include an Sn-Ag alloy, an Sn-Cu alloy, an Sn-Ag-Cu alloy, an Sn-Ag-Sb alloy, an Sn-Ag-Sb-Zn alloy, an Sn-Ag-Cu-Zn alloy, an Sn-Ag-Cu-Sb alloy, an Sn-Ag-Bi alloy, an Sn-Bi alloy, an Sn-Ag-Cu-Bi alloy, an Sn-Ag-In-Bi alloy, an Sn-Sb alloy, an Sn-Bi-Cu alloy, an Sn-Bi-Cu-Zn alloy, an Sn-Bi-Zn alloy, an Sn-Bi-Sb-Zn alloy, an Sn-Zn alloy, an Sn-In alloy, an Sn-Zn-In alloy, and an Sn-Pb alloy.

Among the tin alloy particles, specifically tin alloy particles of Sn-3.5Ag, Sn-0.7Cu, Sn-3.2Ag-0.5Cu, Sn-4Ag-0.5Cu, Sn-2.5Ag-0.8Cu-0.5Sb, Sn-2Ag-7.5Bi, Sn-3Ag-5Bi, Sn-58Bi, Sn-3.5Ag-3In-0.5Bi, Sn-3Bi-8Zn, Sn-9Zn, Sn-52In, Sn-40Pb or the like have the melting points same as Sn (232°C) or even lower. Consequently, the tin alloy particles can be used favorably, because they melt at an early stage of sintering to cover the surface of a phosphorus-containing copper alloy particle and can react homogeneously with the phosphorus-containing copper alloy particle. With respect to an expression of a tin alloy particle, for example, Sn-AX-BY-CZ means a tin alloy particle contains A% by mass of element X, B% by mass of element Y, and C% by mass of element Z.

In the present invention, the tin-containing particles may be used singly or used in a combination of 2 or more.

The tin-containing particle may further contain another atom which may unavoidably mix therein. Examples of an unavoidably mixing atom include Ag, Mn, Sb, Si, K, Na, Li, Ba, Sr, Ca, Mg, Be, Zn, Pb, Cd, Tl, V, Al, Zr, W, Mo, Ti, Co, Ni, and Au.

The content of another atom in the tin-containing particle may be for example 3% by mass or less of the tin-containing particle, and from perspectives of the melting point and the reactivity with a phosphorus-containing copper alloy particle it is preferably 1% by mass or less.

There is no particular restriction on the average particle diameter of the tin-containing particle and D50% of the tin-containing particles is preferably 0.5 µm to 20 µm, more preferably 1 µm to 15 µm, and further preferably 5 µm to 15 µm. When it is 0.5 µm or more, the oxidation resistance of a tin-containing particle itself can be improved. While, when it is 20 µm or less, the contact area in an electrode with a phosphorus-containing copper alloy particle and a nickel-containing particle is increased to promote effectively a reaction during sintering.

Further, there is no particular restriction on the shape of the tin-containing particle, and it may be any of an approximately spherical shape, a flat shape, a block shape, a plate shape, a scale-like shape, or the like. From the perspectives of oxidation resistance and low volume resistivity, it is preferably an approximately spherical shape, a flat shape, or a plate shape.

Further, there is no particular restriction on the content of a tin-containing particle in the paste composition for an electrode according to the present invention. Among others, when the total content of the phosphorus-containing copper alloy particle and the tin-containing particle and the nickel-containing particle is 100% by mass, the content of a tin-containing particle is preferably from 5% by mass to 70% by mass, more preferably from 7% by mass to 65% by mass, further preferably from 9% by mass to 60% by mass and particularly preferably from 9% by mass to 45% by mass.

When the content of a tin-containing particle is 5% by mass or more, the reaction with a phosphorus-containing copper alloy particle and a nickel-containing particle can be progressed more homogeneously. Further, when a tin-containing particle is set at 70% by mass or less, a sufficient volume of Cu-Sn alloy phase and Cu-Sn-Ni alloy phase can be formed to lower the volume resistivity of an electrode.

The content of the tin-containing particle in the paste composition for an electrode can be measured by using a high frequency inductively-coupled plasma atomic emission spectrometer (ICP-AES) or a high frequency inductively-coupled plasma mass spectrometer (ICP-MS). When the content of the tin-containing particle is measured using these apparatuses, the content of the tin-containing particle is measured by using a paste composition from which the solvent has been removed.

### (Nickel-containing particle)

The paste composition for an electrode according to the present invention contains at least one nickel-containing particle. By containing a nickel-containing particle in addition to the phosphorus-containing copper alloy particle and nickel-containing particle, oxidation resistance can be exhibited at higher temperature in a sintering process.

There is no particular restriction on the nickel-containing particle, insofar as it is a particle containing nickel. Among others, it is preferably at least one selected from the group consisting of nickel particles and nickel alloy particles, and preferably at least one selected from the group consisting of nickel particles and nickel alloy particles having a nickel content of 1% by mass or more.

There is no particular restriction on the purity of nickel in a nickel particle. For example, the purity of a nickel particle may be 95% by mass or more, is preferably 97% by mass or more, and more preferably 99% by mass or more.

There is no restriction on the kind of an alloy for a nickel alloy particle, insofar as it is an alloy particle containing nickel. Among others, from perspectives of the melting point of a nickel alloy particle and the reactivity with a phosphorus-containing copper alloy particle, a tin-containing copper alloy particle and a Cu-Sn alloy phase, a nickel alloy particle with the nickel content of 1% by mass or more is preferable, a nickel alloy particle with the nickel content of 3% by mass or more is more preferable, a nickel alloy particle with the nickel content of 5% by mass or more is further preferable, and a nickel alloy particle with the nickel content of 10% by mass or more is especially preferable.

The content of the nickel in the nickel-containing particle can be measured by using an X-ray fluorescence (XRF) spectrometer, for example, Type MESA-500W manufactured by HORIBA, Ltd.

Examples of a nickel alloy particle include a Ni-Fe alloy, a Ni-Cu alloy, a Ni-Cu-Zn alloy, a Ni-Cr alloy, a Ni-Cr-Ag alloy. In particular, the nickel alloy particles such as Ni-58Fe, Ni-75Cu, Ni-6Cu-20Zn can be used favorably, because they can react homogeneously with the phosphorus-containing copper alloy particle and tin-containing particle. With respect to an expression of a nickel alloy particle, for example, Ni-AX-BY-CZ means a nickel alloy particle contains A% by mass of element X, B% by mass of element Y, and C% by mass of element Z.

According to the present invention, the nickel-containing particles may be used singly or used in a combination of 2 or more.

The nickel-containing particle may further contain another atom which may unavoidably mix therein. Examples of an unavoidably mixing atom include Ag, Mn, Sb, Si, K, Na, Li, Ba, Sr, Ca, Mg, Be, Zn, Pb, Cd, Tl, V, Al, Zr, W, Mo, Ti, Co, Sn, and Au.

The content of another atom in the nickel-containing particle may be for example 3% by mass or less of the nickel-containing particle, and from perspectives of the melting point and the reactivity with a phosphorus-containing copper alloy particle and tin-containing particle it is preferably 1% by mass or less.

There is no particular restriction on the average particle diameter of the nickel-containing particle and D50% of the nickel-containing particles is preferably 0.5 µm to 20 µm, more preferably 1 µm to 15 µm, and further preferably 5 µm to 15 µm. When it is 0.5 µm or more, the oxidation resistance of a nickel-containing particle itself can be improved. While, when it is 20 µm or less, the contact area in an electrode with a phosphorus-containing copper alloy particle and a tin-containing particle can be increased to promote more effectively a reaction with the phosphorus-containing copper alloy particle and the tin-containing particle.

There is no particular restriction on the shape of the nickel-containing particle, and it may be any of an approximately spherical shape, a flat shape, a block shape, a plate shape, a scale shape, or the like. From the perspectives of oxidation resistance and low volume resistivity, it is preferably approximately a spherical shape, a flat shape, or a plate shape.

Further, there is no particular restriction on the content of a nickel-containing particle in the paste composition for an electrode according to the present invention. Among others, when the total content of the phosphorus-containing copper alloy particle, the tin-containing particle, and the nickel-containing particle is 100% by mass, the content of a nickel-containing particle is preferably from 10% by mass to 60% by mass, more preferably from 12% by mass to 55% by mass, further preferably from 15% by mass to 50% by mass and particularly preferably from 15% by mass to 35% by mass.

When the content of a nickel-containing particle is 10% by mass or more, the formation of Cu-Sn-Ni alloy phase can be progressed more homogeneously. Further, when a nickel-containing particle is set at 70% by mass or less, a sufficient volume of Cu-Sn-Ni alloy phase can be formed to lower volume resistivity of an electrode.

The content of the nickel-containing particle in the paste composition for an electrode can be measured by using a high frequency inductively-coupled plasma atomic emission spectrometer (ICP-AES) or a high frequency inductively-coupled plasma mass spectrometer (ICP-MS). When the content of the nickel-containing particle is measured using these apparatuses, the content of the nickel-containing particle is measured by using a paste composition from which the solvent has been removed.

There is no particular restriction on the content ratio of the tin-containing particle and the nickel-containing particle in the paste composition for an electrode. From the perspective of adhesiveness to the silicon substrate, the mass ratio of the nickel-containing particle to the tin-containing particle (nickel-containing particle / tin-containing particle) is preferably 0.3 to 4.0 and more preferably 0.4 to 3.0.

In addition, there is no particular restriction on the content ratio of the phosphate-containing copper alloy particle, and the tin-containing particle and the nickel-containing particle in the paste composition for an electrode. From the perspective of the low volume resistivity of an electrode to be formed in a sintering condition at high temperature and from the perspective of adhesiveness to the silicon substrate, the mass ratio of the total amount of the tin particle-containing particle and the nickel-containing particle to the phosphate-containing copper alloy particle ((nickel-containing particle + tin-containing particle) / phosphate-containing copper alloy particle) is preferably 0.4 to 1.8, and more preferably 0.6 to 1.4.

Further, there is no particular restriction on the ratio of the average particle diameter (D50%) of the tin-containing particle and the average particle diameter (D50%) of the nickel-containing particle in the paste composition for an electrode. From the perspectives of the homogeneity of the Sn-P-O glass phase to be formed and from the perspective of adhesiveness to the silicon substrate, the ratio of the average particle diameter (D50%) of the nickel-containing particle to the average particle diameter (D50%) of the tin particle-containing particle (nickel-containing particle / tin-containing particle) is preferably 0.05 to 20, and more preferably 0.5 to 10.

In addition, there is no particular restriction on the ratio of the average particle diameter (D50%) of the phosphate-containing copper alloy and the average particle diameter (D50%) of the tin-containing particle in the paste composition for an electrode. From the perspective of the low volume resistivity of an electrode to be formed in a sintering condition at high temperature and from the perspective of adhesiveness to the silicon substrate, the ratio of the average particle diameter (D50%) of the tin-containing particle to the average particle diameter (D50%) of the phosphate-containing copper alloy particle (tin-containing particle / phosphate-containing copper alloy) is preferably 0.03 to 30, and more preferably 0.1 to 10.

In addition, there is no particular restriction on the ratio of the average particle diameter (D50%) of the phosphate-containing copper alloy and the average particle diameter (D50%) of the nickel-containing particle in the paste composition for an electrode. From the perspective of the low volume resistivity of an electrode to be formed in a sintering condition at high temperature, the ratio of the average particle diameter (D50%) of the nickel-containing particle to the average particle diameter (D50%) of the phosphate-containing copper alloy particle (nickel-containing particle / phosphate-containing copper alloy) is preferably 0.02 to 20, and more preferably 0.1 to 10.

### (Glass Particles)

The paste composition for an electrode according to the present invention contains at least one of glass particle. Since the paste composition for an electrode contains a glass particle, the adhesiveness of an electrode portion with a substrate is increased during sintering. In addition, especially in the formation of an electrode at the light receiving side of a photovoltaic cell, a silicon nitride film which is an anti-reflection film is removed by a so-called fire-through during sintering, and an ohmic contact between the electrode and the silicon substrate is formed.

From the perspectives of adhesiveness to a silicon substrate and low volume resistivity of the electrode, a glass particle containing glass having a glass softening point of 650°C or lower and a crystallization initiation temperature of higher than 650°C is preferred. Further, the glass softening point is measured by a conventional method using a Thermo Mechanical Analyzer (TMA), for example Type TMA-60 manufactured by SHIMADZU CORPORATION, and the crystallization initiation temperature is measured by a conventional method using a Thermo Gravimetry/Differential Thermal Analyzer (TG/DTA), for example Type DTG-60H manufactured by SHIMADZU CORPORATION.

Specifically, in, for example, a thermal expansion curve measured by the TMA, an intersection point is obtained between two tangent lines from two different tangent points. A temperature corresponding to the intersection point is identified as the glass softening point. Further, an exothermic peak is identified from an analysis curve of the TG-DTA, and an intersection point is obtained between a tangent line from a tangent point before the exothermic region of the analysis curve and a tangent line from a tangent point between starting point of exothermic region and the exothermic peak of the analysis curve. A temperature corresponding to the intersection point is identified as the crystallization initiation temperature.

When the paste composition for an electrode is used as an electrode of light receiving surface side, any known glass particles in the related art may be used without any particular limitation, provided that the glass particles softened or melted at an electrode-forming temperature to contact with the silicon nitride, thereby oxidizing the silicon nitride and incorporating the oxidized silicon dioxide thereof to remove antireflective film.

The glass particles generally included in a paste composition for an electrode may be constituted with lead-containing glass, at which silicon dioxide can be efficiently incorporated. Examples of such lead-containing glass include those described in Japanese Patent No. 03050064 and the like, which can be suitably used in the present invention.

Furthermore, in the present invention, in consideration of the effect on the environment, it is preferable to use lead-free glass which does not substantially contain lead. Examples of the lead-free glass include lead-free glass described in Paragraphs 0024 to 0025 of JP-A No. 2006-313744, and lead-free glass described in JP-A No. 2009-188281 and the like, and it is also preferable to appropriately select one from the lead-free glass as above and apply it in the present invention.

When the paste composition for an electrode is used as, for example, an rear surface extraction electrode, a through hole electrode in a back-contact type photovoltaic cell element, and a rear surface electrode except for an electrode of light receiving surface of a photovoltaic cell, a glass particle which does not contain an ingredient required for fire-through such as lead can be used.

Examples of the glass component constituting the glass particles used in the paste composition for an electrode include silicon dioxide (SiO₂), phosphorous oxide (P₂O₅), aluminum oxide (Al₂O₃), boron oxide (B₂O₃), vanadium oxide (V₂O₅), potassium oxide (K₂O), bismuth oxide (Bi₂O₃), sodium oxide (Na₂O), lithium oxide (Li₂O), barium oxide (BaO), strontium oxide (SrO), calcium oxide (CaO), magnesium oxide (MgO), beryllium oxide (BeO), zinc oxide (ZnO), lead oxide (PbO), cadmium oxide (CdO), tin oxide (SnO), zirconium oxide (ZrO₂), tungsten oxide (WO₃), molybdenum oxide (MoO₃), lanthanum oxide (La₂O₃), niobium oxide (Nb₂O₅), tantalum oxide (Ta₂O₅), yttrium oxide (Y₂O₃), titanium oxide (TiO₂), germanium oxide (GeO₂), tellurium oxide (TeO₂), lutetium oxide (Lu₂O₃), antimony oxide (Sb₂O₃), copper oxide (CuO), iron oxide (FeO), silver oxide (Ag₂O), and manganese oxide (MnO).

Among these, a glass particle containing at least one glass component selected from the group consisting of SiO₂, P₂O₅, Al₂O₃, B₂O₃, V₂O₅, Bi₂O₃, ZnO, and PbO is preferably used, and a glass particle containing at least one glass component selected from the group consisting of SiO₂, Al₂O₃, B₂O₃, Bi₂O₃, and PbO is more preferably used. With such a glass particle, the softening point can be lowered more effectively. Further, since the wettability with a phosphorus-containing copper alloy particle, a tin-containing particle, a nickel-containing particle, and a silver particle which may be contained as necessary, is improved, sintering among the particles in the sintering process proceeds well and an electrode having lower volume resistivity can be formed.

Meanwhile, from the perspective of low contact resistivity, a glass particle containing phosphorus pentoxide (phosphate glass, P₂O₅ based glass particle) is preferable, and a glass particle containing vanadium pentoxide in addition to phosphorus pentoxide (P₂O₅-V₂O₅ based glass particle) is more preferable. By containing additionally vanadium pentoxide, the oxidation resistance improves further, and the resistivity of an electrode decreases further. The above is apparently attributable to decrease in the glass softening point by containing additionally, for example, vanadium pentoxide. If a phosphorus pentoxide -vanadium pentoxide glass particle (P₂O₅-V₂O₅ glass particle) is used, the content of vanadium pentoxide based on the total mass of the glass is preferably 1% by mass or more, and more preferably 1% by mass to 70% by mass.

There is no particular restriction on the average particle diameter of a glass particle according to the present invention, and the average particle diameter at an accumulated weight of 50% (D50%) is preferably from 0.5 µm to 10 µm, and more preferably from 0.8 µm to 8 µm. When it is 0.5 µm or more, the workability in producing a paste composition for an electrode is improved. Further, when it is 10 µm or less, the particle can be dispersed homogeneously in a paste composition for an electrode, and fire-through can efficiently take place in a sintering process, and further the adhesiveness to a silicon substrate is improved.

Further, there is no particular restriction on the shape of the glass particle, and it may be any of an approximately spherical shape, a flat shape, a block shape, a plate shape, a scale shape, or the like. From the perspective of oxidation resistance and low volume resistivity, it is preferably an approximately spherical shape, a flat shape, or a plate shape.

The content of the glass particle based on the total mass of a paste composition for an electrode is preferably 0.1% by mass to 10% by mass, more preferably 0.5% by mass to 8% by mass, and further preferably 1% by mass to 8% by mass. When the glass particle is contained in the content range, oxidation resistance, lower electrode volume resistivity, and lower contact resistivity can be attained more effectively, and the reaction between the phosphorus-containing copper alloy particle and, the tin-containing particle and nickel-containing particle can be promoted.

The content of the glass particle in the paste composition for an electrode can be measured by using a high frequency inductively-coupled plasma atomic emission spectrometer (ICP-AES) or a high frequency inductively-coupled plasma mass spectrometer (ICP-MS). When the content of the glass particle is measured using these apparatuses, the content of the glass particle is measured by using a paste composition from which the solvent has been removed.

The ratio of the content of the glass particle to the total content of a phosphorus-containing copper alloy particle, a tin-containing particle, a nickel-containing particle and a silver particle, which may be contained as needed in a paste composition for an electrode is preferably from 0.01 to 0.15%, and more preferably 0.03 to 0.12. When the glass particle is contained in such content range, oxidation resistance, lower electrode volume resistivity, and lower contact resistivity can be attained more effectively, and the reaction between the phosphorus-containing copper alloy particle and, the tin-containing particle and nickel-containing particle can be promoted.

Further, the ratio of the average particle diameter (D50%) of the glass particle to the average particle diameter (D50%) of a phosphorus-containing copper alloy particle in a paste composition for an electrode is preferably from 0.05 to 100, and more preferably 0.1 to 20. When the glass particle is contained in such range, oxidation resistance, lower electrode volume resistivity, and lower contact resistivity can be attained more effectively, and the reaction between the phosphorus-containing copper alloy particle and, the tin-containing particle and nickel-containing particle can be promoted.

### (Solvent and Resin)

The paste composition for an electrode according to the present invention contains at least one solvent and at least one resin, thereby enabling adjustment of the liquid physical properties (for example, viscosity and surface tension) of the paste composition for an electrode according to the present invention in accordance with the application method of the paste composition to a silicon substrate or the like.

The solvent is not particularly limited. Examples of the solvent include hydrocarbon-based solvents such as hexane, cyclohexane, and toluene; chlorinated hydrocarbon-based solvents such as dichloroethylene, dichloroethane, and dichlorobenzene; cyclic ether-based solvents such as tetrahydrofuran, furan, tetrahydropyran, pyran, dioxane, 1,3-dioxolane, and trioxane; amide-based solvents such as N,N-dimethylformamide and N,N-dimethylacetamide; sulfoxide-based solvents such as dimethylsulfoxide and diethylsulfoxide; ketone-based solvents such as acetone, methyl ethyl ketone, diethyl ketone, and cyclohexanone; alcohol-based compounds such as ethanol, 2-propanol, 1-butanol, and diacetone alcohol; polyhydric alcohol ester-based solvents such as 2,2,4-trimethyl-1,3-pentanediol monoacetate, 2,2,4-trimethyl-1,3-pentanediol monopropionate, 2,2,4-trimethyl-1,3-pentanediol monobutyrate, 2,2,4-trimethyl-1,3-pentanediol monoisobutyrate, 2,2,4-triethyl-1,3-pentanediol monoacetate, ethylene glycol monobutyl ether acetate, and diethylene glycol monobutyl ether acetate; polyhydric alcohol ether-based solvents such as butyl cellosolve, diethylene glycol monoburyl ether, and diethylene glycol diethyl ether; terpene-based solvents such as terpineol which includes α-terpineol, terpinene which includes α-terpinene, pinene which includes α-pinene and β-pinene, myrcene, alloocimene, limonene, dipentene, carvone, ocimene, and phellandrene, and mixtures thereof.

As the solvent in the present invention, from the perspectives of applicability and printability when forming the paste composition for an electrode on a silicon substrate, at least one selected from the group consisting of polyhydric alcohol ester-based solvents, terpene-based solvents, and polyhydric alcohol ether-based solvents is preferred, and at least one selected from the group consisting of polyhydric alcohol ester-based solvents and terpene-based solvents is more preferred. In the present invention, the solvents may be used singly or in combination of two or more kinds thereof.

Furthermore, as the resin, a resin that is generally used in the art can be used without any limitation as long as it is a resin that is thermally decomposable by sintering. The resin may be a natural polymer compound or a synthetic polymer compound. Specific examples of the resin include cellulose-based resins such as methyl cellulose, ethyl cellulose, carboxymethyl cellulose, and nitrocellulose; polyvinyl alcohols; polyvinyl pyrrolidones; acryl resins; vinyl acetate-acrylic ester copolymers; butyral resins such as polyvinyl butyral; alkyd resins such as phenol-modified alkyd resins and castor oil fatty acid-modified alkyd resins; epoxy resins; phenol resins; and rosin ester resins.

As the resin in the present invention, from the perspective of the loss at a time of sintering, at least one selected from the group consisting of cellulose-based resins and acryl resins is preferred, and at least one selected from cellulose-based resins is more preferred. In the present invention, the resins may be used singly or in combination of two or more kinds thereof.

There is no particular restriction on the weight-average molecular weight of the resin according to the present invention. Among others, the weight-average molecular weight is preferably from 5,000 or more to 500,000 or less, and more preferably from 10,000 or more to 300,000 or less. When the weight-average molecular weight of the resin is 5, 000 or more, increase in the viscosity of a paste composition for an electrode can be suppressed. This is apparently attributable to, for example, mutual aggregation of particles due to insufficient steric repulsion when the resin is adsorbed on a phosphorus-containing copper alloy particle, a tin-containing particle, and a nickel-containing particle. Meanwhile, when the weight-average molecular weight of the resin is 500,000 or less, mutual aggregation of the resins in a solvent is suppressed and increase in the viscosity of a paste composition for an electrode can be suppressed.

Additionally, when the weight-average molecular weight of the resin is 500,000 or less, increase in the combustion temperature of the resin can be suppressed, and when a paste composition for an electrode is subjected to sintering, appearance of a residual foreign material due to incomplete combustion of the resin can be suppressed, to form an electrode having lower volume resistivity.

The contents of the solvent and the resin in a paste composition for an electrode according to the present invention can be selected appropriately depending on a desired liquid property and the kinds of the solvent and the resin to be used. For example, the total content of the solvent and the resin is preferably from 3% by mass to 29.9% by mass, more preferably from 5% by mass to 25% by mass, and further preferably from 7% by mass to 20% by mass, with respect to the total mass of a paste composition for an electrode.

When the total content of the solvent and the resin is within the range, the application property in applying a paste composition for an electrode to a silicon substrate becomes favorable, and an electrode having a desired width and height can be formed easier.

Further, with respect to a paste composition for an electrode according to the present invention, from the perspectives of oxidation resistance and low volume resistivity of an electrode, preferably the total content of a phosphorus-containing copper alloy particle, a tin-containing particle, and a nickel-containing particle is from 70% by mass to 94% by mass, the content of a glass particle is from 0.1% by mass to 10% by mass, and the total content of a solvent and a resin is from 3% by mass to 29.9% by mass; more preferably the total content of a phosphorus-containing copper alloy particle, a tin-containing particle, and a nickel-containing particle is from 74% by mass to 88% by mass, the content of a glass particle is from 0.5% by mass to 8% by mass, and the total content of a solvent and a resin is from 7% by mass to 20% by mass; and further preferably the total content of a phosphorus-containing copper alloy particle, a tin-containing particle, and a nickel-containing particle is from 74% by mass to 88% by mass, the content of a glass particle is from 1% by mass to 8% by mass, and the total content of a solvent and a resin is from 7% by mass to 20% by mass.

### (Silver Particle)

It is preferable that the paste composition for an electrode further contain a silver particle. By containing a silver particle, the oxidation resistance increases and volume resistivity of an electrode to be formed decreases. Further by separation of an Ag particle in a Sn-P-O glass phase generated by a reaction between the phosphorus-containing copper alloy particle and the tin-containing particle, the ohmic contact between a Cu-Sn-Ni alloy phase and Cu-Sn alloy phase in an electrode layer and a silicon substrate improves further. Additionally, when assembled to a photovoltaic cell module, an effect of improving the solder wetting property can be obtained.

Silver that constitutes the silver particle may further contain other atoms which are inevitably incorporated. Examples of other atoms which are inevitably incorporated include Sb, Si, K, Na, Li, Ba, Sr, Ca, Mg, Be, Zn, Pb, Cd, Tl, V, Sn, Al, Zr, W, Mo, Ti, Co, Ni, and Au.

The content of other atoms in the silver particle may be, for example, 3% by mass or less of the silver particle, and from the perspectives of the melting point and decrease in electrode volume resistivity it is preferably 1% by mass or less.

There is no particular restriction on the average particle diameter of a silver particle according to the present invention, and the average particle diameter at an accumulated weight of 50% (D50%) is preferably from 0.4 µm to 10 µm, and more preferably from 1 µm to 7 µm. When it is 0.4 µm or more, the oxidation resistance is improved more effectively. When it is 10 µm or less, the contact area between a silver particle and a phosphorus-containing copper alloy particle, tin-containing particle and nickel-containing particle in an electrode can be larger, and the resistivity decreases more effectively.

Further, there is no particular restriction on the shape of the silver particle, and it may be any of an approximately spherical shape, a flat shape, a block shape, a plate shape, a scale shape, or the like. From the perspectives of oxidation resistance and low volume resistivity, however, it is preferably an approximately spherical shape, a flat shape, or a plate shape.

Further, in cases where the paste composition for an electrode contains a silver particle, the content of a silver particle is preferably from 0.1 % by mass to 10% by mass, and more preferably from 0.5% by mass to 8% by mass, with respect to the total content of the phosphorus-containing copper alloy particle, the tin-containing particle, the nickel-containing particle, and the silver particle as 100% by mass.

The content of the silver particle can be measured by using an X-ray fluorescence (XRF) spectrometer, for example, Type MESA-500W manufactured by HORIBA, Ltd.

With respect to the paste composition for an electrode according to the present invention, from the perspectives of oxidation resistance, low volume resistivity of an electrode, and applicability to a silicon substrate, the total content of a phosphorus-containing copper alloy particle, a tin-containing particle, a nickel-containing particle and a silver particle in the paste composition for an electrode is preferably from 70% by mass to 94% by mass, and more preferably from 74% by mass to 88% by mass. When the total content of a phosphorus-containing copper alloy particle, a tin-containing particle, a nickel-containing particle, and a silver particle is 70% by mass or more, a favorable viscosity for applying a paste composition for an electrode can be obtained easily. While, when the total content of a phosphorus-containing copper alloy particle, a tin-containing particle, a nickel-containing particle, and a silver particle is 94% by mass or less, appearance of a scarcely coated spot in applying a paste composition for an electrode can be more effectively suppressed.

When the paste composition for an electrode according to the present invention contains a silver particle additionally, from the perspectives of oxidation resistance and low volume resistivity of an electrode, preferably the total content of a phosphorus-containing copper alloy particle, a tin-containing particle, a nickel-containing particle, and a silver particle is from 70% by mass to 94% by mass, the content of a glass particle is from 0.1 % by mass to 10% by mass, and the total content of a solvent and a resin is from 3% by mass to 29.9% by mass; more preferably the total content of a phosphorus-containing copper alloy particle, a tin-containing particle, a nickel-containing particle, and a silver particle is from 74% by mass to 88% by mass, the content of a glass particle is from 0.5% by mass to 8% by mass, and the total content of a solvent and a resin is from 7% by mass to 20% by mass; and further preferably the total content of a phosphorus-containing copper alloy particle, a tin-containing particle, a nickel-containing particle, and a silver particle is from 74% by mass to 88% by mass, the content of a glass particle is from 1% by mass to 8% by mass, and the total content of a solvent and a resin is from 7% by mass to 20% by mass.

### (Flux)

The paste composition for an electrode may further contain at least one flux. By containing a flux, an oxidized film formed on a surface of a phosphorus-containing copper alloy particle can be removed and a reducing reaction of a phosphorus-containing copper alloy particle during sintering can be promoted. Further, melting of a tin-containing particle during sintering is also promoted to promote a reaction with a phosphorus-containing copper alloy particle, resulting in improvement of the oxidation resistance to lower the volume resistivity of a formed electrode. Additionally, an effect of enhancing the adhesion between an electrode material and a silicon substrate can be obtained.

The flux is not particularly limited as long as it can remove an oxide film formed on the surface of the phosphorus-containing copper alloy particle and can accelerate the melting of the tin-containing particle. Specific preferable examples of the flux include fatty acids, boric acid compounds, fluoride compounds, and fluoroborate compounds.

More specific examples thereof include lauric acid, myristic acid, palmitic acid, stearic acid, sorbic acid, stearol acid, propionic acid, boron oxide, potassium borate, sodium borate, lithium borate, potassium fluoroborate, sodium fluoroborate, lithium fluoroborate, acidic potassium fluoride, acidic sodium fluoride, acidic lithium fluoride, potassium fluoride, sodium fluoride, and lithium fluoride.

Among those, from the perspective of heat resistance at a time of sintering the electrode material (a property that the flux is not volatilized at a low sintering temperature) and complementing the oxidation resistance of the phosphorous-containing copper alloy particle, particularly preferable examples of the flux include potassium borate and potassium fluoroborate.

In the present invention, these fluxes can be respectively used singly or in combination of two or more kinds thereof.

When the paste composition for an electrode contains a flux, the content of the flux in the paste composition for an electrode is preferably from 0.1% by mass to 5% by mass, more preferably from 0.3% by mass to 4% by mass, even more preferably from 0.5% by mass to 3.5% by mass, particularly preferably from 0.7% by mass to 3% by mass, and extremely preferably from 1% by mass to 2.5% by mass, based on the total mass of the paste composition for an electrode, from the perspective of effectively exhibiting the oxidation resistance of the phosphorous-containing copper alloy particle to promote the melting of the tin-containing particle and from the perspective of reducing the porosity of a portion from which the flux is removed at a time of completion of the sintering of the electrode material.

### (Other Components)

Furthermore, the paste composition for an electrode according to the present invention may further contain, in addition to the above-described components, other components generally used in the art, if necessary. Examples of other components include a plasticizer, a dispersant, a surfactant, an inorganic binder, a metal oxide, a ceramic, and an organic metal compound.

The method for preparing the paste composition for an electrode according to the present invention is not particularly limited. The paste composition for an electrode according to the present invention may be prepared by dispersing and mixing the phosphorous-containing copper alloy particle, the tin-containing particle, the nickel-containing particle, the glass particle, the solvent, the resin, and the silver particle to be added as necessary, and the like, using a method that is generally used for dispersing or mixing. A method for dispersing or mixing is not particularly limited, and the method may be selected appropriately from methods that are generally used for dispersing or mixing.

### <Method for Producing Electrode Using Paste Composition for Electrode>

As for the method for preparing an electrode using the paste composition for an electrode, the paste composition for an electrode can be applied to a region in which the electrode is to be formed, dried, and then sintered to form the electrode in a desired region. By using the paste composition for an electrode, an electrode having low volume resistivity can be formed even with a sintering treatment in the presence of oxygen (for example, in the atmosphere).

Specifically, for example, when an electrode for a photovoltaic cell is formed using the paste composition for an electrode, the paste composition for an electrode can be applied onto a silicon substrate to have a desired shape, dried, and then sintered to form an electrode for a photovoltaic cell having a low resistivity in a desired shape. Further, by using the paste composition for an electrode, an electrode having a low resistivity can be formed even with a sintering treatment in the presence of oxygen (for example, in the atmosphere). Furthermore, the electrode formed on the silicon substrate can have an excellent adhesiveness with the silicon substrate, and form a favorable ohmic contact.

Examples of the method for applying the paste composition for an electrode include screen printing, an ink-jet method, and a dispenser method, and from the perspective of the productivity, application by screen printing is preferred.

In a case in which the paste composition for an electrode is applied by screen printing, it is preferable that the paste composition for an electrode have a viscosity in the range from 20 Pa·s to 1000 Pa·s. The viscosity of the paste composition for an electrode is measured using a Brookfield HBT viscometer at 25°C.

The amount of the paste composition for an electrode to be applied can be appropriately selected according to the size of the electrode to be formed or the like. For example, the amount of the paste composition for an electrode to be applied can be from 2 g/m² to 10 g/m², and preferably from 4 g/m² to 8 g/m².

Moreover, as a heat treatment condition (sintering condition) when forming an electrode using the paste composition for an electrode according to the present invention, heat treatment conditions generally used in the art can be applied. Generally, the heat treatment temperature (sintering temperature) is from 800°C to 900°C, but when using the paste composition for an electrode according to the present invention, a heat treatment condition can be applied in a wide range from a lower temperature heat treatment condition to a generally used heat treatment condition, and for example, an electrode having favorable characteristics can be formed at a wide range of heat treatment temperature of from 450°C to 900°C.

In addition, the heat treatment time can be appropriately selected according to the heat treatment temperature and the like, and it may be, for example, 1 second to 20 seconds.

As a heat treatment apparatus, an apparatus that is able to increase the temperature to the above described temperature may be used appropriately. Examples thereof include an infrared heating oven, and a tunnel oven. In a case of an infrared heating oven, electrical energy is input directly to a heated material in a form of an electromagnetic wave and converted to thermal energy, and therefore the efficiency is high, and rapid heating in a short time period is possible. Further, since there is no combustion product, and it is noncontact heating, contamination of a produced electrode can be prevented. In a case of a tunnel oven, since a sample is conveyed automatically and continuously from an inlet to an outlet to undergo sintering, homogeneous sintering is possible by segmentation of the oven and control of the conveying speed. From the perspective of the electricity generation performance of a photovoltaic cell element, heat treatment using a tunnel oven is favorable.

### <Photovoltaic cell and method for producing the same>

A photovoltaic cell element according to the present invention at least includes: a silicon substrate having a pn-junction; and an electrode which is a sintered product of the paste composition for an electrode applied on to the silicon substrate. As the result, a photovoltaic cell element having favorable characteristics can be obtained, and the productivity of the photovoltaic cell element is superior.

Meanwhile, the term "photovoltaic cell element" means herein an element having a silicon substrate having a pn-junction and an electrode formed on the silicon substrate. Further, the term "photovoltaic cell" means an assembly constituted, according to need, by connecting by means of a wiring material plural photovoltaic cell elements, whose electrodes are provided with the wiring material, and encapsulated by an encapsulation resin.

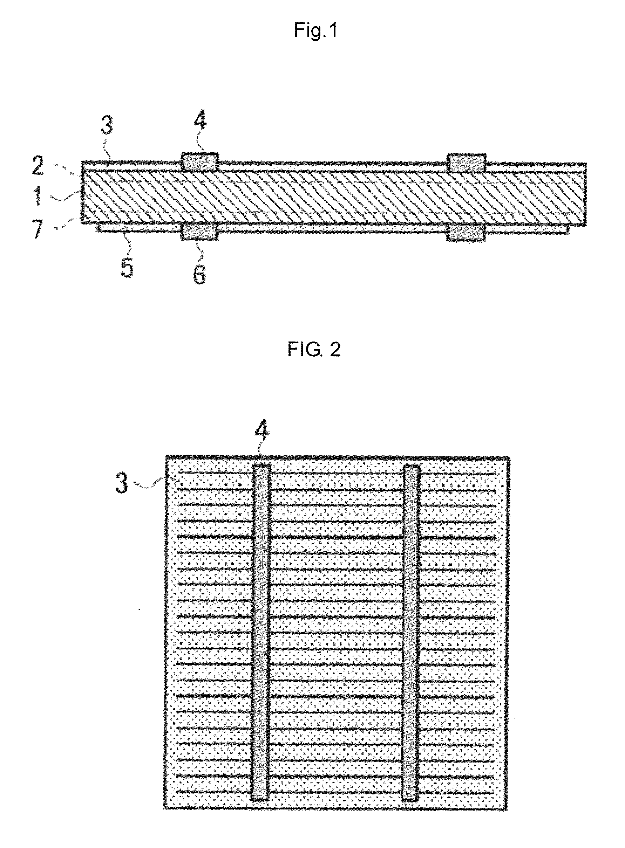

Specific examples of a photovoltaic cell element according to the present invention will be described below with reference to the drawings, provided that the present invention be not limited thereto. Figure 1, Figure 2, and Figure 3 show a cross-sectional view, schematic views of a light receiving surface and a back surface of an example of a typical photovoltaic cell element.

As illustrated in a schematic cross-sectional view in Figure 1, in the vicinity of the surface of one side of the semiconductor substrate 1 an n⁺ diffusion layer 2 is formed, and on the n⁺ diffusion layer 2 a power output electrode 4 and an antireflection coating 3 are formed. In the vicinity of the surface of the other side of the semiconductor substrate, a p⁺ diffusion layer 7 is formed, and on the p⁺ diffusion layer 7 a back surface power output electrode 6 and a back surface collecting electrode 5 are formed. As a semiconductor substrate 1 of a photovoltaic cell element, a monocrystalline or polycrystalline silicon, or the like is usually utilized. The semiconductor substrate 1 contains boron or the like constituting a p-type semiconductor. On the light receiving surface side, asperity (also called as "texture", not illustrated) is formed using an etching solution composed of NaOH and IPA (isopropyl alcohol) to suppress reflection of the sunlight. On this light receiving surface side, phosphorus or the like is doped to provide an n⁺ diffusion layer 2 with the thickness of a sub-micron scale, and at a boundary with a p-type bulk, a pn-junction region is formed. Further, on the light receiving surface side, an antireflection coating 3 made of silicon nitride or the like is provided on the n⁺ diffusion layer 2 with the film thickness of approximately 90 nm by means of PECVD or the like.

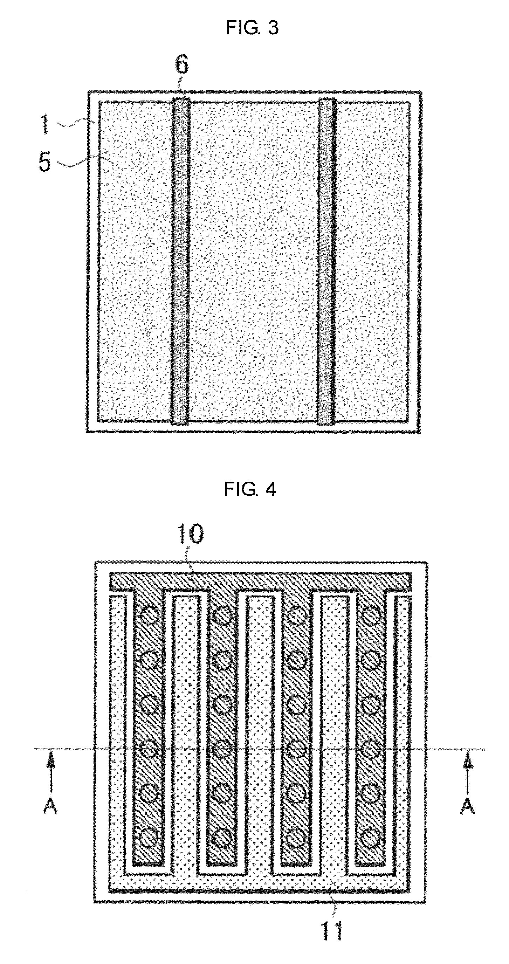

Next, a method for forming a light receiving surface electrode 4 provided on the light receiving surface side as outlined in Figure 2, and a collecting electrode 5 and a power output electrode 6 to be formed on the back surface as outlined in Figure 3 will be described.

A light receiving surface electrode 4 and a back surface power output electrode 6 are formed with the paste composition for an electrode. Meanwhile, a back surface collecting electrode 5 is formed with an aluminum electrode paste composition containing a glass powder. As the first example of methods for forming a light receiving surface electrode 4, a back surface collecting electrode 5, and a back surface power output electrode 6, the paste compositions are coated by screen printing or the like in desired patterns, dried and sintered simultaneously in the atmosphere at approximately 450°C to 900°C, to thereby form the electrodes. According to the present invention, by using the paste composition for an electrode, an electrode superior in resistivity and contact resistivity can be formed even by sintering at a relatively low temperature.

On that occasion, on the light receiving surface side, a glass particle contained in the paste composition for an electrode forming the light receiving surface electrode 4 reacts with (fire-through) the antireflection layer 3 to establish an electrical connection (ohmic contact) between the light receiving surface electrode 4 and the n⁺ diffusion layer 2.

According to the present invention, by forming a light receiving surface electrode 4 with the paste composition for an electrode, oxidization of the copper can be suppressed even though copper is contained as a conductive metal, and a light receiving surface electrode 4 with low resistivity can be formed at a high productivity.

Further, according to the present invention, a formed electrode preferably contains a Cu-Sn-Ni alloy phase and, as necessary, a Cu-Sn alloy phase and an Sn-P-O glass phase, and it is more preferably that the Sn-P-O glass phase is provided between the Cu-Sn alloy phase or the Cu-Sn-Ni alloy phase and a silicon substrate (not illustrated). By this means, a reaction between copper and a silicon substrate is suppressed and an electrode having low volume resistivity and superior adhesiveness can be formed.

On the back surface side, aluminum in the aluminum electrode paste composition forming a back surface collecting electrode 5 diffuses into the back surface of the semiconductor substrate 1 during sintering to form a p⁺ diffusion layer 7, thereby establishing an ohmic contact between the semiconductor substrate 1 and the back surface collecting electrode 5 and the back surface power output electrode 6.

As the second example of methods for forming a light receiving surface electrode 4, a back surface collecting electrode 5 and a back surface power output electrode 6, a method including: firstly printing an aluminum electrode paste composition that forms a back surface collecting electrode 5, followed by drying and sintering in the atmosphere at approximately 750°C to 900°C, to thereby form a back surface collecting electrode 5; and then printing the paste composition for an electrode according to the present invention on each of the light receiving surface side and the back surface side, followed by drying and then sintering in the atmosphere at approximately 450°C to 650°C, to thereby form a light receiving surface electrode 4 and a back surface power output electrode 6.

This method is effective for the following case, for example. Namely, when a sintering temperature is 650°C or less for sintering an aluminum electrode paste to form a back surface collecting electrode 5, sintering of the aluminum particle and diffusion amount of aluminum into a semiconductor substrate 1 may be insufficient depending on the composition of the aluminum paste, which may cause insufficient formation of a p⁺ diffusion layer. In such a situation, an adequate ohmic contact cannot be established on the back surface between a semiconductor substrate 1 and a back surface collecting electrode 5 and a back surface power output electrode 6, and the electricity generation performance of a photovoltaic cell element may be lowered. Therefore, it is preferable that a back surface collecting electrode 5 is firstly formed at a sintering temperature optimal to the aluminum electrode paste composition (for example, 750°C to 900°C), and then the paste composition for an electrode is printed, dried, and sintered at a relatively low temperature (450°C to 650°C) to form a light receiving surface electrode 4 and a back surface power output electrode 6.

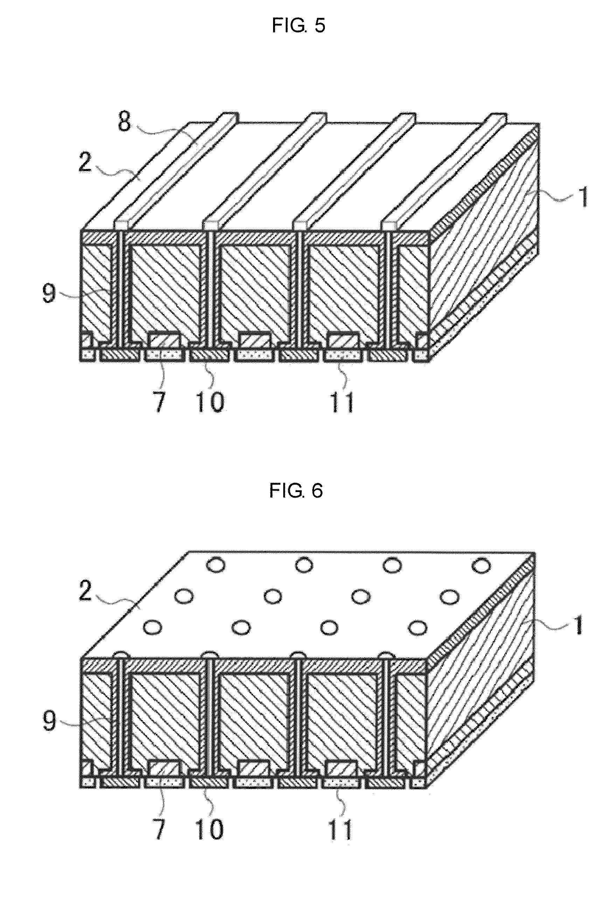

Further, a schematic plan view of the back surface side electrode structure common to a so-called back-contact type photovoltaic cell element as another embodiment of the present invention is shown in Figure 4, and perspective views showing outlined structures of photovoltaic cell elements, which are different embodiments of a back-contact type photovoltaic cell element, in Figure 5, Figure 6 and Figure 7 respectively. Figure 5, Figure 6 and Figure 7 are perspective views along the AA cross-section in Figure 4.

In a photovoltaic cell element having a structure shown in the perspective view of Figure 5, through-holes are formed through the semiconductor substrate 1 penetrating both the light receiving surface side and the back surface side by laser drilling, etching, or the like. On the light receiving surface side, a texture (not illustrated) that enhances the light incidence efficiency is formed. Additionally, on the light receiving surface side, an n⁺ diffusion layer 2 is formed by means of an n type diffusion treatment and an antireflection film (not illustrated) is formed on the n⁺ diffusion layer 2. They can be formed by the same process as for a conventional crystalline silicon type photovoltaic cell element.

Next, into the previously prepared through-holes, the paste composition for an electrode according to the present invention is filled by means of a printing method or an ink jet method, and on the light receiving surface side, similarly the paste composition for an electrode according to the present invention is printed in a grid form, to form a composition layer constituting a through-hole electrode 9 and a light receiving surface collecting electrode 8.

In this regard, with respect to the pastes for filling and for printing, pastes having different compositions in terms of viscosity or the like which are optimized to the respective processes are preferably utilized, but both filling and printing may be carried out using a paste having a single composition.

Meanwhile, on the back surface side, in order to prevent recombination of carriers, an n⁺ diffusion layer 2 and a p⁺ diffusion layer 7 are formed. In this case, as an impurity element forming a p⁺ diffusion layer 7, boron (B) or aluminum (Al) is used. The p⁺ diffusion layer 7 may be formed for example by exercising a thermal diffusing treatment using boron as a diffusion source in a production process of a photovoltaic cell element before forming the antireflection coating; or in a case in which aluminum is used, it may be formed by printing and sintering an aluminum paste on the opposite surface side in the printing process.

On the back surface side, as shown in a plan view of Figure 4, back surface electrodes 10 and 11 are formed by printing the paste composition for an electrode according to the present invention in a stripe form on an n⁺ diffusion layer 2 and a p⁺ diffusion layer 7 respectively. In a case in which the p⁺ diffusion layer 7 is formed using an aluminum paste, back surface electrodes may be formed in such a manner that the paste composition for an electrode is used only on the n⁺ diffusion layer 2 side.

Followed by drying and sintering in the atmosphere at approximately 450°C to 900°C, a light receiving surface collecting electrode 8, a through-hole electrode 9, and back surface electrodes 10, 11 are formed. As mentioned above, when an aluminum electrode is used for either of the back surface electrodes, from the perspectives of a sintering property of aluminum and a ohmic contact property between a back surface electrode and a p⁺ diffusion layer 7, the aluminum paste is printed and sintered to form either of the back surface electrodes in advance, and then the paste composition for an electrode may be printed or filled and sintered to form a light receiving surface collecting electrode 8, a through-hole electrode 9, and the other back surface electrode.

A photovoltaic cell element having a structure shown in a perspective view of Figure 6 can be produced in the same manner as the photovoltaic cell element having a structure shown in a perspective view of Figure 5, except that a light receiving surface collecting electrode is not formed. Namely, in a photovoltaic cell element having a structure shown in a perspective view of Figure 6, the paste composition for an electrode according to the present invention can be used for a through-hole electrode 9 and back surface electrodes 10, 11.

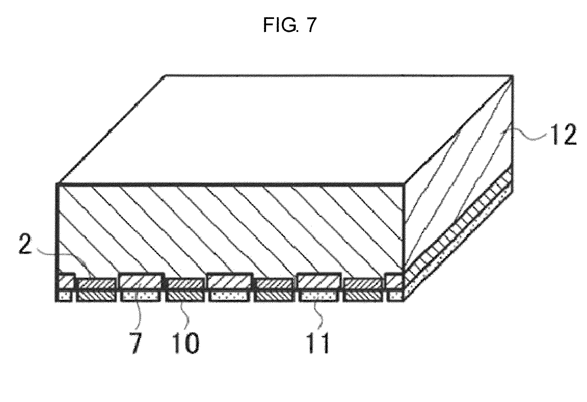

Further, a photovoltaic cell element having a structure shown in a perspective view of Figure 7 can be formed in the same manner as the photovoltaic cell element having a structure shown in a perspective view of Figure 5, except that an n-type silicon substrate is used as a basic semiconductor substrate, and a through-hole is not formed. Namely, in a photovoltaic cell element having a structure shown in a perspective view of Figure 7, the paste composition for an electrode according to the present invention can be used for back surface electrodes 10, 11.

The application of the paste composition for an electrode is not limited to a photovoltaic cell electrode as described above, and it may be favorably applied also to electrode wiring and shield wiring for a plasma display, a ceramic capacitor, an antenna circuit, various sensor circuits, a heat radiating material for a semiconductor device, etc. Among them, it can be used favorably especially for forming an electrode on a substrate containing silicon.

### <Photovoltaic cell>

A photovoltaic cell according to the present invention is constituted by including: at least one photovoltaic cell element mentioned above; and a wiring material is provided on an electrode of the photovoltaic cell element. If necessary, the photovoltaic cell may be also constituted by including plural photovoltaic cell elements connected by means of a wiring material, and may be encapsulated using an encapsulation material. There is no particular restriction on the wiring material and the encapsulation material, and any one may be selected from those used commonly in the art.

### [Examples]

Hereinbelow, the present invention will be described in detail with reference to Examples, but the present invention is not limited to these Examples. Further, unless otherwise specified, "parts" and "%" are based on mass.

### <Example 1>

### (a) Preparation of paste composition for electrode

A phosphorus-containing copper alloy containing 7% by mass of phosphorus was prepared according to a conventional method, dissolved and pulverized by a water atomization process, followed by dying and classification. The classified powders were blended, and subjected to deoxigenation and dehydration treatments, thereby producing a phosphorus-containing copper alloy particle containing 7% by mass of phosphorus. The average particle diameter (D50%) of the phosphorus-containing copper alloy particle was 5.0 µm and the shape thereof was approximately spherical.

The shape of the phosphorus-containing copper alloy particle was judged by observation with a scanning electron microscope (TM-1000, manufactured by Hitachi High-Technologies Corporation). The average particle diameter of the phosphorus-containing copper alloy particle was calculated with a laser diffraction average particle diameter analyzer (measurement wave length: 632 nm, LS 13 320, manufactured by Beckman Coulter, Inc.).

A glass (hereinafter occasionally abbreviated as "G01") composed of silicon dioxide (SiO₂) 3 parts, lead oxide (PbO) 60 parts, boron oxide (B₂O₃) 18 parts, bismuth oxide (Bi₂O₃) 5 parts, aluminum oxide (Al₂O₃) 5 parts, and zinc oxide (ZnO) 9 parts was prepared. The obtained glass G01 had a softening point of 420°C, and a crystallization temperature thereof was higher than 650°C.

Using the obtained glass G01, a glass G01 particle with an average particle diameter (D50%) of 2.5 µm was produced. The shape thereof was approximately spherical.

The glass particle shape was judged by observation with a scanning electron microscope (TM-1000, manufactured by Hitachi High-Technologies Corporation). The average particle diameter of the glass particle was calculated by using a laser diffraction average particle diameter analyzer (measurement wave length: 632 nm, LS 13 320, manufactured by Beckman Coulter, Inc.). The softening point of the glass particle was determined by a differential thermal (DTA) curve obtained by using DTG-60H TG/DTA Simultaneous Measuring Instrument (manufactured by Shimadzu Corporation).

The obtained phosphorus-containing copper alloy particle 33.3 parts, a tin particle (Sn; average particle diameter (D50%) of 5.0 µm; purity of 99.9%) 22.8 parts, nickel particle (Ni; average particle diameter (D50%) of 5.0 µm; purity of 99.9%) 22.8 parts, the glass G01 particle 7.8 parts, diethylene glycol monobutyl ether (BC) 11.7 parts and ethyl polyacrylate (EPA) 2.2 parts were blended, and mixed using an automatic mortar kneading machine to make a paste, thereby preparing a paste composition 1 for an electrode.

### (b) Production of photovoltaic cell element

A p-type semiconductor substrate with a thickness of 190 µm, which had an n⁺ diffusion layer, a texture and an antireflection coating (silicon nitride film) formed on the light receiving surface thereof was prepared, and a specimen in a size of 125 mm×125 mm was cut out therefrom. On the light receiving surface thereof, the paste composition 1 for an electrode obtained as above was printed by a screen printing method to form an electrode pattern as shown in Figure 2. The electrode pattern was constituted of 150 µm-wide finger lines and 1.5 mm-wide bus bars, and the printing conditions (screen mesh size, printing speed, and printing pressure) were adjusted appropriately to obtain a layer thickness after sintering of 20 µm. The specimen was then placed in an oven heated to 150°C for 15 minutes to evaporate off the solvent.

Next, on the opposite surface to the light receiving surface (hereinafter, also referred to as "back surface"), the paste composition 1 for an electrode and an aluminum electrode paste were printed similarly as above by a screen printing method, thereby forming an electrode pattern as shown in Figure 3.

The pattern of the back surface power output electrode formed from the paste composition 1 for an electrode was of 123 mm×5 mm, and printed at 2 places in total. The printing conditions (screen mesh size, printing speed, and printing pressure) were adjusted appropriately to obtain a layer thickness of the back surface power output electrode after sintering of 20 µm. The aluminum electrode paste was printed on the entire surface except the back surface power output electrode, to thereby form a back surface collecting electrode pattern. The printing conditions of the aluminum electrode paste were adjusted appropriately to obtain a layer thickness of the back surface collecting electrode after sintering of 30 µm. The specimen was placed in an oven heated to 150°C for 15 minutes to evaporate off the solvent.

Next, a heat treatment (sintering) was conducted using a tunnel oven (1-line W/B conveyor tunnel furnace, by Noritake Co., Limited) in the atmosphere for the retention time of 10 seconds with a maximum sintering temperature of 800°C, thereby producing a photovoltaic cell element 1 having desired electrodes.

### <Example 2>

A photovoltaic cell element 2 was produced in the same manner as Example 1, except that the sintering condition for forming electrodes was changed from 10 seconds with a maximum temperature of 800°C in Example 1 to 8 seconds with a maximum temperature of 850°C.

### <Example 3>

A photovoltaic cell element 3 was produced using a paste composition 3 for an electrode in the same manner as Example 1, except that the phosphorus content of the phosphorus-containing copper alloy particle was changed from 7% by mass in Example 1 to 6% by mass.

### <Example 4>

A photovoltaic cell element 4 was produced using a paste composition 4 for an electrode in the same manner as Example 1, except that the phosphorus content of the phosphorus-containing copper alloy particle was changed from 7% by mass in Example 1 to 8% by mass.

### <Example 5>

A photovoltaic cell element 5 was produced using a paste composition 5 for an electrode in the same manner as Example 1, except that the sintering condition for forming electrodes was changed from 10 seconds with a maximum temperature of 800°C in Example 1 to 8 seconds with a maximum temperature of 850°C.

### <Example 6>

A photovoltaic cell element 6 was produced using a paste composition 6 for an electrode in the same manner as Example 1, except that the average particle diameter (D50%) of the phosphorus-containing copper alloy particle was changed from 5.0 µm in Example 1 to 1.5 µm.

### <Example 7>

A photovoltaic cell element 7 was produced using a paste composition 7 for an electrode in the same manner as Example 1, except that the contents of the phosphorus-containing copper alloy particle, the tin-containing particle and the nickel-containing particle in Example 1 were changed to the content of the phosphorus-containing copper alloy particle of 36.5 parts, the content of the tin-containing particle of 25.4 parts, and the content of the nickel-containing particle of 16.4 parts.

### <Example 8>

A photovoltaic cell element 8 was produced using a paste composition 8 for an electrode in the same manner as Example 1, except that the contents of the phosphorus-containing copper alloy particle, the tin-containing particle and the nickel-containing particle in Example 1 were changed to the contents of the phosphorus-containing copper alloy particle of 46.5 parts, the content of the tin-containing particle of 9.4 parts, and the content of the nickel-containing particle of 22.4 parts.

### <Example 9>

A photovoltaic cell element 9 was produced using a paste composition 9 for an electrode in the same manner as Example 1, except that as the tin-containing particle, a tin alloy particle composed of Sn-4Ag-0.5Cu (Sn alloy containing 4% by mass of Ag and 0.5% by mass of Cu) was used instead of the tin particle (Sn) used in Example 1, and the average particle diameter (D50%) thereof was 8.0 µm.

### <Example 10>

A photovoltaic cell element 10 was produced using a paste composition 10 for an electrode in the same manner as Example 1, except that as the nickel-containing particle, a nickel alloy particle composed of Ni-60Cu (Ni alloy containing 60% by mass of Cu) was used instead of the nickel particle (Ni) used in Example 1, and the average particle diameter (D50%) thereof was 7.0 µm.

### <Example 11 >

A photovoltaic cell element 11 was produced using a paste composition 11 for an electrode in the same manner as Example 1, except that the average particle diameter (D50%) of the nickel-containing particle (Ni) was changed from 5.0 µm in Example 1 to 10.0 µm.

### <Example 12>

To the paste composition for an electrode in Example 1, a silver particle (Ag; average particle diameter (D50%) 3.0 µm; purity 99.5%) was added. More specifically, a photovoltaic cell element 12 was produced using a paste composition 12 for an electrode in the same manner as Example 1, except that the contents of the respective ingredients were changed to 32.3 parts for the phosphorus-containing copper alloy particle, 21.8 parts for the tin particle, 20.2 parts for the nickel particle, 4.0 parts for the silver particle, 7.8 parts for the glass G01 particle, 11.7 parts for diethylene glycol monobutyl ether (BC), and 2.2 parts for ethyl polyacrylate (EPA).

### <Example 13>

The content of the glass G01 particle used in Example 1 was changed. More specifically, a photovoltaic cell element 13 was produced using a paste composition 13 for an electrode in the same manner as Example 1, except that the contents of the respective ingredients were changed to 34.3 parts for the phosphorus-containing copper alloy particle, 23.7 parts for the tin particle, 23.2 parts for the nickel particle, 4.9 parts for the glass G01 particle, 11.7 parts for diethylene glycol monobutyl ether (BC), and 2.2 parts for ethyl polyacrylate (EPA).

### <Example 14>

A photovoltaic cell element 14 was produced using a paste composition 14 for an electrode in the same manner as Example 1, except that the composition of the glass particle was changed from the glass G01 used in Example 1 to a glass G02 described below.

The glass G02 was prepared to have a composition of vanadium oxide (V₂O₅) 45 parts, phosphorus oxide (P₂O₅) 24.2 parts, barium oxide (BaO) 20.8 parts, antimony oxide (Sb₂O₃) 5 parts, and tungsten oxide (WO₃) 5 parts. The softening point of the glass G02 was 492°C, and the crystallization initiation temperature thereof was higher than 650°C.

Using the obtained glass G02 a glass, G02 particle with an average particle diameter (D50%) of 2.5 µm was prepared. The shape thereof was approximately spherical.

### <Example 15>

The solvent used in Example 1 was changed from diethylene glycol monobutyl ether to terpineol (Ter) and the resin was changed from polyacrylate to ethyl cellulose (EC), respectively. More specifically, a photovoltaic cell element 15 was produced using a paste composition 15 for an electrode in the same manner as Example 1, except that the contents of the respective ingredients were changed to 33.3 parts for the phosphorus-containing copper alloy particle, 22.8 parts for the tin particle, 22.2 parts for the nickel particle, 7.8 parts for the glass G01 particle, 13.5 parts for terpineol (Ter) and 0.4 parts for ethyl cellulose (EC).

### <Examples 16 to 20>

Paste compositions 16 to 20 for an electrode were prepared in the same manner as Example 1, except that the phosphorus content, average particle diameter (D50%) and content of the phosphorus-containing copper alloy particle, the composition, average particle diameter (D50%) and content of the tin-containing particle, the composition, average particle diameter (D50%) and content of the nickel-containing particle, the content of the silver particle, the type and content of the glass particle, the type and content of the solvent, and the type and content of the resin used in Example 1 were changed as shown in Table 1 and Table 2.

Next, photovoltaic cell elements 16 to 20 provided with desired electrodes were produced in the same manner as Example 1, respectively, except that the respective obtained paste compositions 16 to 20 for an electrode were used, and the temperature and treatment time of the heat treatment were changed as shown in Table 1 and Table 2.

### <Example 21>

A p-type semiconductor substrate having a thickness of 190 µm and having an n⁺ diffusion layer, a texture and an antireflection coating (silicon nitride film) formed on the light receiving surface thereof was prepared, and a specimen in a size of 125 mm×125 mm was cut out therefrom. Then, on the back surface, an aluminum electrode paste was printed to form a back surface collecting electrode pattern. The back surface collecting electrode pattern was printed on the entire surface except the back surface power output electrode as shown in Figure 3. The printing conditions of the aluminum electrode paste were adjusted appropriately to obtain a layer thickness of the back surface collecting electrode after sintering of 30 µm. The specimen was placed in an oven heated to 150°C for 15 minutes to evaporate off the solvent.

Next, a heat treatment (sintering) was conducted using a tunnel oven (1-line W/B conveyor tunnel furnace, by Noritake Co., Limited) in the atmosphere for the retention time of 10 seconds with a maximum sintering temperature of 800°C, thereby producing a back surface collecting electrode and a p⁺ diffusion layer.

Next, the paste composition 1 for an electrode obtained as above was printed to form electrode patterns as shown in Figure 2 and Figure 3. The electrode pattern on the light receiving surface was constituted of 150 µm-wide finger lines and 1.5 mm-wide bus bars, and the printing conditions (screen mesh size, printing speed, and printing pressure) were adjusted appropriately to obtain the layer thickness after sintering of 20 µm. The pattern of the back surface electrode was constituted of 123 mm×5 mm and printed at total 2 places with a layer thickness of 20 µm. The specimen was placed in an oven heated to 150°C for 15 minutes to evaporate off the solvent.

Subsequently, the specimen was subjected to a heat treatment (sintering) using a tunnel oven (1-line W/B conveyor tunnel furnace, by Noritake Co., Limited) in the atmosphere for the retention time of 10 seconds with a maximum sintering temperature of 650°C, thereby producing a photovoltaic cell element 21 provided with desired electrodes.

### <Example 22>

A photovoltaic cell element 22 was produced in the same manner as Example 21, except that the paste composition 3 for an electrode obtained as above was used for forming the light receiving surface electrode and the back surface power output electrode.

### <Example 23>

A photovoltaic cell element 23 was produced in the same manner as Example 21, except that the paste composition 9 for an electrode obtained as above was used for forming the light receiving surface electrode and the back surface power output electrode, and that the sintering condition for forming the electrodes was changed from 10 seconds with a maximum temperature of 650°C to 10 seconds with a maximum temperature of 620°C.

### <Example 24>

Using the paste composition 1 for an electrode obtained as above, a photovoltaic cell element 24 having a structure as shown in Figure 5 was produced. A specific production method will be described below. Firstly, through-holes with diameters of 100 µm were formed in the p-type silicon substrate, which penetrated both the light receiving surface side and the back surface side, using a laser drill. Then, on the light receiving surface side, a texture, an n⁺ diffusion layer, and an antireflection coating were formed successively. In this regard, the n⁺ diffusion layer was also formed in the through-holes, and on a part of the back surface respectively. Then, the paste composition 1 for an electrode was filled in the preformed through-holes by an ink jet method and additionally printed on the light receiving surface side in a grid form.

On the other hand, on the back surface side, a pattern as shown in Figure 4 was printed in a stripe form using the paste composition 1 for an electrode, so that the paste composition for an electrode layer was printed below the through-holes. An aluminum electrode paste was printed on the region other than the layer formed from the paste composition for an electrode, thereby forming an aluminum electrode paste layer. The specimen was subjected to a heat treatment using a tunnel oven (1-line W/B conveyor tunnel furnace, by Noritake Co., Limited) in the atmosphere for the retention time of 10 seconds with a maximum sintering temperature of 800°C, thereby producing a photovoltaic cell element 24 provided with desired electrodes.

In this case, at a part onto which the aluminum electrode paste layer had been formed, a p⁺ diffusion layer was formed by the diffusion of Al into the p-type silicon substrate by sintering.

### <Example 25>

A photovoltaic cell element 25 was produced in the same manner as Example 24, except that the paste composition 1 for an electrode used in Example 24 was changed to the paste composition 16 for an electrode obtained as above to form the light receiving surface collecting electrode, the through-hole electrode, and the back surface electrode.

### <Example 26>

A photovoltaic cell element 26 was produced in the same manner as Example 24, except that the sintering condition for forming electrodes was changed from 10 seconds with a maximum temperature of 800°C to 8 seconds with a maximum temperature of 850°C.

### <Example 27>

A photovoltaic cell element 27 was produced in the same manner as Example 24, except that the paste composition 1 for an electrode used in Example 24 was changed to the paste composition 9 for an electrode obtained as above to form the light receiving surface collecting electrode, the through-hole electrode, and the back surface electrode.

### <Example 28>

A paste composition 28 for an electrode was prepared in the same manner as Example 1, except that the glass particle was changed from the glass G01 particle used in Example 1 to a glass G03 particle.

The glass G03 was prepared to have a composition of silicon dioxide (SiO₂) 13 parts, boron oxide (B₂O₃) 58 parts, zinc oxide (ZnO) 38 parts, aluminum oxide (Al₂O₃) 12 parts, and barium oxide (BaO) 12 parts. The softening point of the obtained glass G03 was 583°C, and the crystallization temperature thereof was higher than 650°C.

Using the obtained glass G03, the glass G03 particle with an average particle diameter (D50%) of 2.5 µm was obtained. The shape thereof was approximately spherical.

Then, using the paste composition 28 for an electrode obtained as above, a photovoltaic cell element 28 having a structure as shown in Figure 6 was produced. The production method was the same as Examples 24 to 27 except that the light receiving surface electrode was not formed. As for the sintering condition, the retention time was 10 seconds with a maximum temperature of 800°C.

### <Example 29>

A photovoltaic cell element 29 was produced in the same manner as Example 28, except that the sintering condition for forming an electrode was changed from 10 seconds with a maximum temperature of 800°C to 8 seconds with a maximum temperature of 850°C.

### <Example 30>

Using the paste composition 28 for an electrode obtained as above, a photovoltaic cell element 30 having a structure as shown in Figure 7 was produced. The production method was the same as Example 24 except that an n-type silicon substrate was used as a basic substrate, and that the light receiving surface electrode, the through-holes and the through-hole electrode were not formed. As for the sintering condition, the retention time was 10 seconds with a maximum temperature of 800°C.

### <Example 31>

A paste composition 31 for an electrode was prepared in the same manner as Example 5, except that the glass particle was changed from the glass G01 particle used in Example 9 to the glass G03 particle. Using this, a photovoltaic cell element 31 having a structure as shown in Figure 7 was produced in the same manner as Example 30.

### <Example 32>

A paste composition 32 for an electrode was prepared in the same manner as Example 16, except that the glass particle was changed from the glass G01 particle used in Example 12 to the glass G03 particle. Using this, a photovoltaic cell element 32 having a structure as shown in Figure 7 was produced in the same manner as Example 30.

### <Comparative Example 1>

A paste composition C1 for an electrode was prepared in the same manner as Example 1, except that the phosphorus-containing copper alloy particle, the tin-containing particle and the nickel-containing particle used in the preparation of the paste composition for an electrode in Example 1 were not used, and that the respective ingredients were changed to have the composition as shown in Table 1 and Table 2.

A photovoltaic cell element C1 was produced in the same manner as Example 1 except that the paste composition C1 for an electrode not containing the phosphorus-containing copper alloy particle, the tin-containing particle and the nickel-containing particle was used.

### <Comparative Examples 2 to 4>

Paste compositions C2 to C4 for an electrode having the compositions shown in Table 1 and Table 2 were prepared except that a phosphorus-containing copper alloy particle having a different phosphorus content was used, and that no tin-containing particle and no nickel-containing particle were used in the preparation of the paste composition for an electrode in Example 1.

Photovoltaic cell elements C2 to C4 were produced in the same manner as in Comparative Example 1 respectively, except that the respective paste compositions C2 to C4 for an electrode were used.

### <Comparative Examples 5>

A paste composition C5 for an electrode was prepared in the same manner as Example 1, except that a copper particle (purity 99.5%; average particle diameter (D50%) 5.0 µm; content 33.3 parts) was used instead of the phosphorus-containing copper alloy particle used in the preparation of the paste composition for an electrode in Example 1, and the compositions of the respective ingredients were changed as shown in Table 1 and Table 2.

A photovoltaic cell element C5 was produced in the same manner as in Comparative Example 1, except that the paste composition C5 for an electrode was used.

### <Comparative Examples 6>

A photovoltaic cell element C6 was produced in the same manner as Example 24, except that the paste composition 1 for an electrode used in Example 24 was changed to the paste composition C1 for an electrode obtained as above to form a light receiving surface collecting electrode, a through-hole electrode, and a back surface electrode were formed.

### <Comparative Example 7>

A photovoltaic cell element C7 was produced in the same manner as Example 28, except that the paste composition 28 for an electrode used in Example 28 was changed to the paste composition C1 for an electrode obtained as above.

### <Comparative Example 8>

A photovoltaic cell element C8 was produced in the same manner as Example 30, except that the paste composition 28 for an electrode used in Example 30 was changed to the paste composition C1 for an electrode obtained as above.

**[Table 1]**

| Example | Phosphorous-containing copper alloy particle | | | Tin-containing particle | | | Nickel-containing particle | | | Silver particle | | Glass particle | | | Solvent | | Resin | |
|---|---|---|---|---|---|---|---|---|---|---|---|---|---|---|---|---|---|---|
| | Phospho -rous content (wt%) | Particle size (D50%) (µm) | Content (part) | Composition | Particle size (D50%) (µm) | Content (part) | Composition | Particle size (D50%) (µm) | Content (part) | Particle size (D50%) (µm) | Content (part) | Kind | Particle size (D50%) (µm) | Content (part) | Kind | Content (part) | Kind | Content (part) |
| Example 1 | 7 | 5.0 | 33.3 | Sn | 5.0 | 22.8 | Ni | 5.0 | 22.2 | - | 0.0 | G01 | 2.5 | 7.8 | BC | 11.7 | EPA | 2.2 |
| Example 2 | 7 | 5.0 | 33.3 | Sn | 5.0 | 22.8 | Ni | 5.0 | 22.2 | - | 0.0 | G01 | 2.5 | 7.8 | BC | 11.7 | EPA | 2.2 |
| Example 3 | 6 | 5.0 | 33.3 | Sn | 5.0 | 22.8 | Ni | 5.0 | 22.2 | - | 0.0 | G01 | 2.5 | 7.8 | BC | 11.7 | EPA | 2.2 |
| Example 4 | 8 | 5.0 | 33.3 | Sn | 5.0 | 22.8 | Ni | 5.0 | 22.2 | - | 0.0 | G01 | 2.5 | 7.8 | BC | 11.7 | EPA | 2.2 |
| Example 5 | 8 | 5.0 | 33.3 | Sn | 5.0 | 22.8 | Ni | 5.0 | 22.2 | - | 0.0 | G01 | 2.5 | 7.8 | BC | 11.7 | EPA | 2.2 |
| Example 6 | 7 | 1.5 | 33.3 | Sn | 5.0 | 22.8 | Ni | 5.0 | 22.2 | - | 0.0 | G01 | 2.5 | 7.8 | BC | 11.7 | EPA | 2.2 |
| Example 7 | 7 | 5.0 | 36.5 | Sn | 5.0 | 25.4 | Ni | 5.0 | 16.4 | - | 0.0 | G01 | 2.5 | 7.8 | BC | 11.7 | EPA | 2.2 |
| Example 8 | 7 | 5.0 | 46.5 | Sn | 5.0 | 9.4 | Ni | 5.0 | 22.4 | - | 0.0 | G01 | 2.5 | 7.8 | BC | 11.7 | EPA | 2.2 |
| Example 9 | 7 | 5.0 | 33.3 | Sn-4Ag -0.5Cu | 8.0 | 22.8 | Ni | 5.0 | 22.2 | - | 0.0 | G01 | 2.5 | 7.8 | BC | 11.7 | EPA | 2.2 |
| Example 10 | 7 | 5.0 | 33.3 | Sn | 8.0 | 22.8 | Ni-60Cu | 7.0 | 22.2 | - | 0.0 | G01 | 2.5 | 7.8 | BC | 11.7 | EPA | 2.2 |
| Example 11 | 7 | 5.0 | 33.3 | Sn | 5.0 | 22.8 | Ni | 10.0 | 22.2 | - | 0.0 | G01 | 2.5 | 7.8 | BC | 11.7 | EPA | 2.2 |
| Example 12 | 7 | 5.0 | 32.3 | Sn | 5.0 | 21.8 | Ni | 10.0 | 20.2 | 3.0 | 4.0 | G01 | 2.5 | 7.8 | BC | 11.7 | EPA | 2.2 |
| Example 13 | 7 | 5.0 | 34.3 | Sn | 5.0 | 23.7 | Ni | 5.0 | 23.2 | - | 0.0 | G01 | 2.5 | 4.9 | BC | 11.7 | EPA | 2.2 |
| Example 14 | 7 | 5.0 | 33.3 | Sn | 5.0 | 22.8 | Ni | 5.0 | 22.2 | - | 0.0 | G02 | 2.5 | 7.8 | BC | 11.7 | EPA | 2.2 |
| Example 15 | 7 | 5.0 | 33.3 | Sn | 5.0 | 22.8 | Ni | 5.0 | 22.2 | - | 0.0 | G01 | 2.5 | 7.8 | Ter | 13.5 | EC | 0.4 |
| Example 16 | 8 | 5.0 | 37.7 | Sn | 5.0 | 25.7 | Ni-6Cu -20Zn | 5.0 | 14.9 | - | 0.0 | G01 | 2.5 | 7.8 | BC | 11.7 | EPA | 2.2 |
| Example 17 | 7 | 10.0 | 32.1 | Sn-58Bi | 5.0 | 29.8 | Ni | 5.0 | 13.6 | 3.0 | 2.8 | G01 | 2.5 | 7.8 | BC | 11.7 | EPA | 2.2 |
| Example 18 | 6 | 5.0 | 37.4 | Sn | 7.0 | 19.8 | Ni | 5.0 | 23.4 | - | 0.0 | G02 | 1.7 | 5.5 | Ter | 13.5 | EC | 0.4 |
| Example 19 | 7 | 5.0 | 30.5 | Sn-4Ag -0.5Cu | 8.0 | 16.8 | Ni | 5.0 | 24.3 | 3.0 | 5.0 | G01 | 2.5 | 7.8 | BC | 13.0 | EPA | 2.6 |
| Example 20 | 7 | 1.5 | 40.5 | Sn | 3.0 | 20.9 | Ni | 5.0 | 20.8 | - | 0.0 | G01 | 1.7 | 3.9 | BC | 11.7 | EPA | 2.2 |
| Example 21 | 7 | 5.0 | 33.3 | Sn | 5.0 | 22.8 | Ni | 5.0 | 22.2 | - | 0.0 | G01 | 2.5 | 7.8 | BC | 11.7 | EPA | 2.2 |
| Example 22 | 6 | 5.0 | 33.3 | Sn | 5.0 | 22.8 | Ni | 5.0 | 22.2 | - | 0.0 | G01 | 2.5 | 7.8 | BC | 11.7 | EPA | 2.2 |
| Example 23 | 7 | 5.0 | 33.3 | Sn-4Ag -0.5Cu | 8.0 | 22.8 | Ni | 5.0 | 22.2 | - | 0.0 | G01 | 2.5 | 7.8 | BC | 11.7 | EPA | 2.2 |
| Example 24 | 7 | 5.0 | 33.3 | Sn | 5.0 | 22.8 | Ni | 5.0 | 22.2 | - | 0.0 | G01 | 2.5 | 7.8 | BC | 11.7 | EPA | 2.2 |
| Example 25 | 8 | 5.0 | 37.7 | Sn | 5.0 | 25.7 | Ni-6Cu -20Zn | 5.0 | 14.9 | - | 0.0 | G01 | 2.5 | 7.8 | BC | 11.7 | EPA | 2.2 |
| Example 26 | 7 | 5.0 | 33.3 | Sn | 5.0 | 22.8 | Ni | 5.0 | 22.2 | - | 0.0 | G01 | 2.5 | 7.8 | BC | 11.7 | EPA | 2.2 |
| Example 27 | 7 | 5.0 | 33.3 | Sn-4Ag -0.5Cu | 8.0 | 22.8 | Ni | 5.0 | 22.2 | - | 0.0 | G01 | 2.5 | 7.8 | BC | 11.7 | EPA | 2.2 |
| Example 28 | 7 | 5.0 | 33.3 | Sn | 5.0 | 22.8 | Ni | 5.0 | 22.2 | - | 0.0 | G03 | 2.5 | 7.8 | BC | 11.7 | EPA | 2.2 |
| Example 29 | 7 | 5.0 | 33.3 | Sn | 5.0 | 22.8 | Ni | 5.0 | 22.2 | - | 0.0 | G03 | 2.5 | 7.8 | BC | 11.7 | EPA | 2.2 |
| Example 30 | 7 | 5.0 | 33.3 | Sn | 5.0 | 22.8 | Ni | 5.0 | 22.2 | - | 0.0 | G03 | 2.5 | 7.8 | BC | 11.7 | EPA | 2.2 |
| Example 31 | 7 | 5.0 | 33.3 | Sn-4Ag -0.5Cu | 8.0 | 22.8 | Ni | 5.0 | 22.2 | - | 0.0 | G03 | 2.5 | 7.8 | BC | 11.7 | EPA | 2.2 |
| Example 32 | 8 | 5.0 | 37.7 | Sn | 5.0 | 25.7 | Ni-6Cu -20Zn | 5.0 | 14.9 | - | 0.0 | G03 | 2.5 | 7.8 | BC | 11.7 | EPA | 2.2 |
| Comparative Example 1 | - | - | 0.0 | - | - | 0.0 | - | - | 0.0 | 3.0 | 78.3 | G01 | 2.5 | 7.8 | BC | 11.7 | EPA | 2.2 |
| Comparative Example 2 | 0 | 5.0 | 78.3 | - | - | 0.0 | - | - | 0.0 | - | 0.0 | G01 | 2.5 | 7.8 | BC | 11.7 | EPA | 2.2 |
| Comparative Example 3 | 1 | 5.0 | 78.3 | - | - | 0.0 | - | - | 0.0 | - | 0.0 | G01 | 2.5 | 7.8 | BC | 11.7 | EPA | 2.2 |
| Comparative Example 4 | 7 | 5.0 | 78.3 | - | - | 0.0 | - | - | 0.0 | - | 0.0 | G01 | 2.5 | 7.8 | BC | 11.7 | EPA | 2.2 |
| Comparative Example 5 | 0 | 5.0 | 33.3 | Sn | 5.0 | 22.8 | Ni | 5.0 | 22.2 | - | 0.0 | G01 | 2.5 | 7.8 | BC | 11.7 | EPA | 2.2 |
| Comparative Example 6 | - | - | 0.0 | - | - | 0.0 | - | - | 0.0 | 3.0 | 78.3 | G01 | 2.5 | 7.8 | BC | 11.7 | EPA | 2.2 |
| Comparative Example 7 | - | - | 0.0 | - | - | 0.0 | - | - | 0.0 | 3.0 | 81.4 | G01 | 2.5 | 4.1 | Ter | 14.1 | EC | 0.4 |
| Comparative Example 8 | - | - | 0.0 | - | - | 0.0 | - | - | 0.0 | 3.0 | 81.4 | G01 | 2.5 | 4.1 | Ter | 14.1 | EC | 0.4 |

**[Table 2]**

| Example | Photovoltaic cell structure | Applied electrode | | | | | With Al electrode only | Sintering condition for single use of Al paste | | Sintering condition for preppared paste composition for electrode | |
|---|---|---|---|---|---|---|---|---|---|---|---|
| | | Light receiving surface collectiong electrode | Light receiving surface power output electrode | Back surface power output electrode | Through-hole electrode | Back surface electrode | | | | | |
| | | | | | | | | Maximunm temperature (°C) | Retention time (sec) | Maximunm temperature (°C) | Retention time (sec) |
| Example 1 | Both surface electrode | yes | yes | yes | no | no | no | - | - | 800 | 10 |
| Example 2 | Both surface electrode | yes | yes | yes | no | no | no | - | - | 850 | 8 |
| Example 3 | Both surface electrode | yes | yes | yes | no | no | no | - | - | 800 | 10 |
| Example 4 | Both surface electrode | yes | yes | yes | no | no | no | - | - | 800 | 10 |
| Example 5 | Both surface electrode | yes | yes | yes | no | no | no | - | - | 850 | 8 |
| Example 6 | Both surface electrode | yes | yes | yes | no | no | no | - | - | 800 | 10 |
| Example 7 | Both surface electrode | yes | yes | yes | no | no | no | - | - | 800 | 10 |
| Example 8 | Both surface electrode | yes | yes | yes | no | no | no | - | - | 800 | 10 |
| Example 9 | Both surface electrode | yes | yes | yes | no | no | no | - | - | 800 | 10 |
| Example 10 | Both surface electrode | yes | yes | yes | no | no | no | - | - | 800 | 10 |
| Example 11 | Both surface electrode | yes | yes | yes | no | no | no | - | - | 800 | 10 |
| Example 12 | Both surface electrode | yes | yes | yes | no | no | no | - | - | 800 | 10 |
| Example 13 | Both surface electrode | yes | yes | yes | no | no | no | - | - | 800 | 10 |
| Example 14 | Both surface electrode | yes | yes | yes | no | no | no | - | - | 800 | 10 |
| Example 15 | Both surface electrode | yes | yes | yes | no | no | no | - | - | 800 | 10 |
| Example 16 | Both surface electrode | yes | yes | yes | no | no | no | - | - | 800 | 10 |
| Example 17 | Both surface electrode | yes | yes | yes | no | no | no | - | - | 800 | 10 |
| Example 18 | Both surface electrode | yes | yes | yes | no | no | no | - | - | 750 | 12 |
| Example 19 | Both surface electrode | yes | yes | yes | no | no | no | - | - | 800 | 10 |
| Example 20 | Both surface electrode | yes | yes | yes | no | no | no | - | - | 850 | 8 |
| Example 21 | Both surface electrode | yes | yes | yes | no | no | yes | 800 | 10 | 650 | 10 |
| Example 22 | Both surface electrode | yes | yes | yes | no | no | yes | 800 | 10 | 650 | 10 |
| Example 23 | Both surface electrode | yes | yes | yes | no | no | yes | 800 | 10 | 620 | 10 |
| Example 24 | Back contact | yes | no | no | yes | yes | no | - | - | 800 | 10 |
| Example 25 | Back contact | yes | no | no | yes | yes | no | - | - | 800 | 10 |
| Example 26 | Back contact | yes | no | no | yes | yes | no | - | - | 850 | 8 |
| Example 27 | Back contact | yes | no | no | yes | yes | no | - | - | 800 | 10 |
| Example 28 | Back contact | no | no | no | yes | yes | no | - | - | 800 | 10 |
| Example 29 | Back contact | no | no | no | yes | yes | no | - | - | 850 | 8 |
| Example 30 | Back contact | no | no | no | no | yes | no | - | - | 800 | 10 |
| Example 31 | Back contact | no | no | no | no | yes | no | - | - | 800 | 10 |
| Example 32 | Back contact | no | no | no | no | yes | no | - | - | 800 | 10 |
| Comparative | Back contact | ○ | ○ | ○ | - | - | no | - | - | 800 | 10 |
| Comparative Example 2 | Both surface electrode | yes | yes | yes | no | no | no | - | - | 800 | 10 |
| Comparative Example 3 | Both surface electrode | yes | yes | yes | no | no | no | - | - | 800 | 10 |
| Comparative Example 4 | Both surface electrode | yes | yes | yes | no | no | no | - | - | 800 | 10 |
| Comparative Example 5 | Both surface electrode | yes | yes | yes | no | no | no | - | - | 800 | 10 |
| Comparative Example 6 | Back contact | yes | no | no | yes | yes | no | - | - | 800 | 10 |
| Comparative Example 7 | Back contact | no | no | no | yes | yes | no | - | - | 800 | 10 |
| Comparative Example 8 | Back contact | no | no | no | no | yes | no | - | - | 800 | 10 |

### <Evaluation>

Evaluation of a produced photovoltaic cell element was carried out in a combination of an artificial sunlight of WXS-155S-10 (by Wacom Electric Co., Ltd.) and a current-voltage (I-V) analyzer I-V Curve Tracer MP-160 (by EKO Instruments Co., Ltd.). Jsc (short circuit current), Voc (open-circuit voltage), FF (fill factor), and Eff (conversion efficiency) representing the electricity generation performance of a photovoltaic cell were obtained by measurements according to JIS-C-8912, JIS-C-8913 and JIS-C-8914. The respective found values on a photovoltaic cell element with a double-surface electrode structure were reduced to relative values based on the found values for Comparative Example 1 (photovoltaic cell element C1) as 100.0 and shown in Table 3. In this regard, for Comparative Example 2, the evaluation was not possible due to high resistivity of the electrode caused by oxidation of the copper particle.

Further, a cross-section of a light-receiving surface electrode formed by baking the prepared paste composition for an electrode was observed by a scanning electron microscope Miniscope TM-1000 (by Hitachi, Ltd.) with the acceleration voltage of 15 kV, to examine existence or nonexistence of a Cu-Sn alloy phase, a Cu-Sn-Ni alloy phase, and an Sn-P-O glass phase in an electrode, as well as a formed location of a Sn-P-O glass phase. The results are also shown in Table 3.

**[Table 3]**

| Examples | Electricity generation performance as photovoltaic cell | | | | Observation result of electrode cross-section structure | | | |
|---|---|---|---|---|---|---|---|---|
| | Jsc (relative value) short circuit current | Voc (relative value) open-circuit voltage | F.F. (relative value) fill factor | Eff (relative value) conversion efficiency | Existence or Nonexistence of Cu-Sn alloy phase | Existence or Nonexistence of Cu-Sn-Ni alloy phase | Sn-P-O glass phase | |
| | | | | | | | Existence or Nonexistence | Formed location |
| Example 1 | 100.8 | 100.3 | 99.8 | 100.2 | Nonexistent | Existent | Existent | Between Cu-Sn-Ni alloy phase - Silicon substrate |
| Example 2 | 100.3 | 100.8 | 100.2 | 100.5 | Nonexistent | Existent | Existent | Between Cu-Sn-Ni alloy phase - Silicon substrate |
| Example 3 | 99.8 | 98.9 | 99.2 | 98.4 | Nonexistent | Existent | Existent | Between Cu-Sn-Ni alloy phase - Silicon substrate |
| Example 4 | 100.2 | 100.1 | 99.3 | 98.9 | Nonexistent | Existent | Existent | Between Cu-Sn-Ni alloy phase - Silicon substrate |
| Example 5 | 100.7 | 100.3 | 101.5 | 101.7 | Nonexistent | Existent | Existent | Between Cu-Sn-Ni alloy phase - Silicon substrate |
| Example 6 | 99.5 | 99.9 | 100.3 | 100.2 | Nonexistent | Existent | Existent | Between Cu-Sn-Ni alloy phase - Silicon substrate |
| Example 7 | 99.3 | 98.4 | 98.1 | 97.9 | Nonexistent | Existent | Existent | Between Cu-Sn-Ni alloy phase - Silicon substrate |
| Example 8 | 100.3 | 101.6 | 100.2 | 100.0 | Nonexistent | Existent | Existent | Between Cu-Sn-Ni alloy phase - Silicon substrate |
| Example 9 | 102.3 | 100.3 | 100.9 | 100.5 | Nonexistent | Existent | Existent | Between Cu-Sn-Ni alloy phase - Silicon substrate |
| Example 10 | 99.4 | 98.0 | 97.2 | 97.2 | Nonexistent | Existent | Existent | Between Cu-Sn-Ni alloy phase - Silicon substrate |
| Example 11 | 99.0 | 98.7 | 100.0 | 99.2 | Nonexistent | Existent | Existent | Between Cu-Sn-Ni alloy phase - Silicon substrate |
| Example 12 | 103.4 | 100.2 | 101.5 | 102.4 | Nonexistent | Existent | Existent | Between Cu-Sn-Ni alloy phase - Silicon substrate |
| Example 13 | 99.9 | 100.4 | 101.0 | 100.4 | Nonexistent | Existent | Existent | Between Cu-Sn-Ni alloy phase - Silicon substrate |
| Example 14 | 101.3 | 100.6 | 100.4 | 100.7 | Nonexistent | Existent | Existent | Between Cu-Sn-Ni alloy phase - Silicon substrate |
| Example 15 | 100.2 | 99.8 | 99.8 | 99.7 | Nonexistent | Existent | Existent | Between Cu-Sn-Ni alloy phase - Silicon substrate |
| Example 16 | 98.7 | 99.0 | 99.5 | 99.2 | Nonexistent | Existent | Existent | Between Cu-Sn-Ni alloy phase - Silicon substrate |
| Example 17 | 98.7 | 97.9 | 98.0 | 97.1 | Nonexistent | Existent | Existent | Between Cu-Sn-Ni alloy phase - Silicon substrate |
| Example 18 | 100.1 | 100.0 | 101.2 | 101.5 | Nonexistent | Existent | Existent | Between Cu-Sn-Ni alloy phase - Silicon substrate |
| Example 19 | 102.4 | 100.0 | 101.9 | 101.6 | Nonexistent | Existent | Existent | Between Cu-Sn-N¡ alloy phase - Silicon substrate |
| Example 20 | 100.9 | 99.4 | 99.8 | 99.2 | Nonexistent | Existent | Existent | Between Cu-Sn-Ni alloy phase - Silicon substrate |
| Example 21 | 100.2 | 100.3 | 100.1 | 99.8 | Existent | Existent | Existent | Between Cu-Sn alloy phase/ Cu-Sn-Ni alloy phase - Silicon substrate |
| Example 22 | 99.8 | 99.4 | 100.0 | 99.5 | Existent | Existent | Existent | Between Cu-Sn alloy phase/ Cu-Sn-Ni alloy phase - Silicon substrate |
| Example 23 | 101.9 | 100.9 | 100.5 | 100.9 | Existent | Existent | Existent | Between Cu-Sn alloy phase/ Cu-Sn-Ni alloy phase - Silicon substrate |
| Comparative Example 1 | 100.0 | 100.0 | 100.0 | 100.0 | - | - | - | - |
| Comparative Example 2 | - | - | - | - | Nonexistent | Nonexistent | Nonexistent | - |
| Comparative Example 3 | 35.6 | 45.2 | 40.4 | 7.2 | Nonexistent | Nonexistent | Nonexistent | - |
| Comparative Example 4 | 39.9 | 38.2 | 37.7 | 18.5 | Nonexistent | Nonexistent | Nonexistent | - |
| Comparative Example 5 | 12.3 | 18.5 | 22.4 | 19.6 | Nonexistent | Nonexistent | Nonexistent | - |

As shown in Table 3, in Comparative Examples 3 to 5, the electricity generation performance deteriorated compared to Comparative Example 1. The above was apparently caused by the following. In Comparative Example 4, since a tin-containing particle was not included, interdiffusion of a silicon substrate and copper took place during baking and the pn-junction quality in the substrate seemingly deteriorated. In Comparative Example 5, since a phosphorus-containing copper alloy particle was not used and pure copper (phosphorus content was 0% by mass) was used, the copper particle was oxidized during baking before reacting with a tin-containing particle and therefore a Cu-Sn alloy phase was not formed, and seemingly the electrode resistivity increased.

On the other hand, the electricity generation performances of the photovoltaic cell elements produced in Examples 1 to 23 were more or less same as the found value for the photovoltaic cell element according to Comparative Example 1. Especially, with respect to the photovoltaic cell elements 21 to 23, although paste compositions for an electrode were baked at a relatively low temperature (620°C to 650°C), high electricity generation performances were exhibited. As the results of structure observation, in the light-receiving surface electrodes a Cu-Sn-Ni alloy phase or both of a Cu-Sn-Ni alloy phase and a Cu-Sn, and an Sn-P-O glass phase were present and the Sn-P-O glass phase was formed between the Cu-Sn alloy phase and the Cu-Sn-Ni alloy phase and the silicon substrate.

Next, the respective found values for back-contact type photovoltaic cell elements having the structure of Figure 5 were reduced to relative values based on the found values in Comparative Example 6 as 100.0, and shown in Table 4. Further, the observation result of a cross-section of a light-receiving surface electrode was also shown in Table 4.

**[Table 4]**

| Examples | Electricity generation performance as photovoltaic cell | | | | Observation result of electrode cross-section structure | | | |
|---|---|---|---|---|---|---|---|---|
| | Jsc (relative value) short circuit current | Voc (relative value) open-circuit voltage | F.F. (relative value) fill factor | Eff (relative value) conversion efficiency | Existence or Nonexistence of Cu-Sn alloy phase | Existence or Nonexistence of Cu-Sn-Ni alloy phase | Sn-P-O glass phase | |
| | | | | | | | Existence or Nonexistence | Formed location |
| Example 24 | 100.2 | 100.1 | 100.3 | 100.7 | Nonexistent | Existent | Existent | Between Cu-Sn-Ni alloy phase - Silicon substrate |
| Example 25 | 99.8 | 100.2 | 99.5 | 99.4 | Nonexistent | Existent | Existent | Between Cu-Sn-Ni alloy phase - Silicon substrate |
| Example 26 | 100.3 | 101.0 | 100.4 | 100.4 | Nonexistent | Existent | Existent | Between Cu-Sn-Ni alloy phase - Silicon substrate |
| Example 27 | 100.1 | 99.5 | 100.5 | 99.8 | Nonexistent | Existent | Existent | Between Cu-Sn-Ni alloy phase - Silicon substrate |
| Comparative Example 6 | 100.0 | 100.0 | 100.0 | 100.0 | - | - | - | - |

As shown in Table 4, the electricity generation performances of the photovoltaic cell elements produced in Examples 24 to 27 were more or less same as the photovoltaic cell element according to Comparative Example 6. As the results of structure observation, in the light-receiving surface electrodes, a Cu-Sn-Ni alloy phase and an Sn-P-O glass phase were present and the Sn-P-O glass phase was formed between the Cu-Sn-Ni alloy phase and the silicon substrate.

Next, the respective found values for back-contact type photovoltaic cell elements having the structure of Figure 6 were reduced to relative values based on the found values in Comparative Example 7 as 100.0, and shown in Table 5. Further, the observation result of a cross-section of an electrode formed by baking a prepared paste composition for an electrode out of back surface electrodes was also shown in Table 5.

**[Table 5]**

| Examples | Electricity generation performance as photovoltaic cell | | | | Observation result of electrode cross-section structure | | | |
|---|---|---|---|---|---|---|---|---|
| | Jsc (relative value) short circuit current | Voc (relative value) open-circuit voltage | F.F. (relative value) fill factor | Eff (relative value) conversion efficiency | Existence or Nonexistence of Cu-Sn alloy phase | Existence or Nonexistence of Cu-Sn-Ni alloy phase | Sn-P-O glass phase | |
| | | | | | | | Existence or Nonexistence | Formed location |
| Example 28 | 100.8 | 100.2 | 100.9 | 100.5 | Nonexistent | Existent | Existent | Between Cu-Sn-Ni alloy phase - Silicon substrate |
| Example 29 | 99.4 | 98.7 | 98.2 | 99.0 | Nonexistent | Existent | Existent | Between Cu-Sn-Ni alloy phase - Silicon substrate |
| Comparative Example 7 | 100.0 | 100.0 | 100.0 | 100.0 | - | - | - | - |

As shown in Table 5, the electricity generation performances of the photovoltaic cell elements produced in Examples 28 to 29 were more or less same as the photovoltaic cell element according to Comparative Example 7. As the results of structure observation, in an electrode formed by baking a prepared paste composition for an electrode out of back-side electrodes, a Cu-Sn-Ni alloy phase and an Sn-P-O glass phase were present and the Sn-P-O glass phase was formed between the Cu-Sn-Ni alloy phase and the silicon substrate.

Next, the respective found values for back-contact type photovoltaic cell elements having the structure of Figure 7 were reduced to relative values based on the found values in Comparative Example 8 as 100.0, and shown in Table 6. Further, the observation result of a cross-section of an electrode formed by baking a prepared paste composition for an electrode among back surface electrodes was also shown in Table 6.

**[Table 6]**

| Examples | Electricity generation performance as photovoltaic cell | | | | Observation result of electrode cross-section structure | | | |
|---|---|---|---|---|---|---|---|---|
| | Jsc (relative value) short circuit current | Voc (relative value) open-circuit voltage | F.F. (relative value) fill factor | Eff (relative value) conversion efficiency | Existence or Nonexistence of Cu-Sn alloy phase | Existence or Nonexistence of Cu-Sn-Ni alloy phase | Sn-P-O glass phase | |
| | | | | | | | Existence or Nonexistence | Formed location |
| Example 30 | 100.2 | 100.4 | 100.8 | 100.4 | Nonexistent | Existent | Existent | Between Cu-Sn-Ni alloy phase - Silicon substrate |
| Example 31 | 103.1 | 100.4 | 101.3 | 100.9 | Nonexistent | Existent | Existent | Between Cu-Sn-Ni alloy phase - Silicon substrate |
| Example 32 | 99.2 | 98.9 | 98.7 | 98.9 | Nonexistent | Existent | Existent | Between Cu-Sn-Ni alloy phase - Silicon substrate |
| Comparative Example 8 | 100.0 | 100.0 | 100.0 | 100.0 | - | - | - | - |

The electricity generation performances of the photovoltaic cell elements produced in Examples 30 to 32 were more or less same as the photovoltaic cell element according to Comparative Example 8. As the results of structure observation, in an electrode formed by baking a prepared paste composition for an electrode out of back-side electrodes, a Cu-Sn-Ni alloy phase and an Sn-P-O glass phase were present and the Sn-P-O glass phase was formed between the Cu-Sn-Ni alloy phase and the silicon substrate.

The entire disclosure of Japanese Patent Application No. 2011-249120 is incorporated herein by reference.

All publications, patent applications, and technical standards mentioned in this specification are herein incorporated by reference to the same extent as if each individual publication, patent application, or technical standard was specifically and individually indicated to be incorporated by reference.

## Claims

1. A paste composition for an electrode, comprising:
a phosphorus-containing copper alloy particle;,
a tin-containing particle;
a nickel-containing particle;
a glass particle;
a solvent; and
a resin.

2. The paste composition for an electrode according to claim 1, wherein a phosphorus content of the phosphorus-containing copper alloy particle is from 6% by mass to 8% by mass.

3. The paste composition for an electrode according to claim 1 or claim 2, wherein the tin-containing particle comprises at least one selected from the group consisting of a tin particle and a tin alloy particle having a tin content of 1% by mass or more.

4. The paste composition for an electrode according to any one of claims 1 to 3, wherein the nickel-containing particle comprises at least one selected from the group consisting of a nickel particle and a nickel alloy particle having a nickel content of 1% by mass or more.

5. The paste composition for an electrode according to any one of claims 1 to 4, wherein the glass particle has a glass softening point of 650°C or less and a crystallization initiation temperature of higher than 650°C.

6. The paste composition for an electrode according to any one of claims 1 to 5, wherein a content of the tin-containing particle is from 5% by mass to 70% by mass when a total content of the phosphorus-containing copper alloy particle, the tin-containing particle, and the nickel-containing particle is 100% by mass.

7. The paste composition for an electrode according to any one of claims 1 to 6, wherein a content of the nickel-containing particle is from 10% by mass to 60% by mass when a total content of the phosphorus-containing copper alloy particle, the tin-containing particle, and the nickel-containing particle is 100% by mass.

8. The paste composition for an electrode according to any one of claims 1 to 7, wherein:
a total content of the phosphorus-containing copper alloy particle, the tin-containing particle, and the nickel-containing particle is from 70% by mass to 94% by mass;
a content of the glass particle is from 0.1% by mass to 10% by mass; and
a total content of the solvent and the resin is from 3% by mass to 29.9% by mass.

9. The paste composition for an electrode according to any one of claims 1 to 8, further comprising a silver particle.

10. The paste composition for an electrode according to claim 9, wherein a content of the silver particle is from 0.1% by mass to 10% by mass when a total content of the phosphorus-containing copper alloy particle, the tin-containing particle, the nickel-containing particle and the silver particle is 100% by mass.

11. The paste composition for an electrode according to claim 9 or claim 10, wherein:
a total content of the phosphorus-containing copper alloy particle, the tin-containing particle, the nickel-containing particle and the silver particle is from 70% by mass to 94% by mass;
a content of the glass particle is from 0.1% by mass to 10% by mass; and
a total content of the solvent and the resin is from 3% by mass to 29.9% by mass.

12. A photovoltaic cell element, comprising:
a silicon substrate having a pn-junction; and
an electrode that is a sintered product of the paste composition for an electrode according to any one of claims 1 to 11 and that has been applied onto the silicon substrate.

13. The photovoltaic cell element according to claim 12, wherein the electrode comprises a Cu-Sn-Ni alloy phase and an Sn-P-O glass phase.

14. The photovoltaic cell element according to claim 13, wherein the Sn-P-O glass phase is arranged between the Cu-Sn-Ni alloy phase and the silicon substrate.

15. A photovoltaic cell, comprising:
the photovoltaic cell element according to any one of claims 12 to 14; and
a wiring material arranged on the electrode of the photovoltaic cell element.
